# EUROPEAN PATENT APPLICATION

(11) **EP 4 682 955 A1**
(43) Date of publication of application: **21.01.2026**
(21) Application number: 25164713.7
(22) Date of filing: 19.03.2025
(51) Int. Cl.: H01L 23/538, H01L 25/065, H01L 23/31, H01L 25/10

(54) **SEMICONDUCTOR PACKAGE**

(30) Priority: 16.07.2024 KR 20240094052
(71) Applicant: Samsung Electronics Co., Ltd., Suwon-si, Gyeonggi-do 16677 (KR)
(72) Inventor: KIM, Ji Hwang, 16677 Suwon-si, Gyeonggi-do (KR); KIM, Dongwook, 16677 Suwon-si, Gyeonggi-do (KR); BAEK, Sangjin, 16677 Suwon-si, Gyeonggi-do (KR)
(74) Representative: Kuhnen & Wacker Patent- und Rechtsanwaltsbüro PartG mbB

(57) **Abstract**

A semiconductor package (200A) may include a first redistribution structure (220), a sub-semiconductor package (100A) on the first redistribution structure (220), where the sub-semiconductor package (100A) may include a second redistribution structure (120), a bridge die (130) on the second redistribution structure (120), a first molding material (160) configured to cover the bridge die (130) on the second redistribution structure (120), a third redistribution structure (170) on the first molding material (160) and on the bridge die (130), a first semiconductor die (180) on the third redistribution structure (170), a second semiconductor die (190) on the third redistribution structure (170), and beside the first semiconductor die (180), where the second semiconductor die (190) is electrically connected to the first semiconductor die (180) through the bridge die (130), and a second molding material (161) configured to cover the first semiconductor die (180) and the second semiconductor die (190), on the third redistribution structure (170), and a third molding material (260) configured to cover the sub-semiconductor package (100A), on the first redistribution structure (220).

## Description

### BACKGROUND OF THE INVENTION

### (a) Field of the Invention

The present disclosure relates to a semiconductor package.

### (b) Description of the Related Art

Semiconductor technology is being developed to manufacture processors by dividing them into chiplets according to their purpose or applied process. If the processor is manufactured by dividing it into chiplets, manufacturing costs can be reduced because chiplets that do not need to use the latest process can be manufactured by using an inexpensive legacy process, and if a defect occurs in a chiplet using the legacy process, only the chiplets using the legacy process may be discarded, which results in improving the yield of the processor. Additionally, manufacturing the processor as a chiplet makes it possible to overcome the performance limitations of conventional single processor chips.

Chiplets are connected to each other by a redistribution layer (RDL) structure under the chiplets and a silicon bridge under the redistribution structure, and the chiplets transmit signals to each other through the redistribution layer and the silicon bridge. In this structure, silicon bridges are disposed between connection members (e.g., solder balls or bumps) under the redistribution structure and are exposed to the outside together with the connection members, and there is a risk that the exposed silicon bridges are damaged by the external environment. Since the redistribution structure disposed between the chiplets and the silicon bridge is required to additionally include a routing path of the silicon bridge, it is bound to have a layer structure of 5 or more layers, and forming a redistribution structure with a layer structure of 5 or more layers increases manufacturing difficulty and reduces the reliability of the redistribution structure.

### SUMMARY OF THE INVENTION

A sub-semiconductor package including semiconductor dies (chiplets) functioning as processors, a redistribution structure, a bridge die, and a passive element die may be included in a package-on-package (PoP) structure, or a 2.5D semiconductor package structure.

According to an aspect of the present disclosure, a semiconductor package may include a first redistribution structure, a sub-semiconductor package on the first redistribution structure, where the sub-semiconductor package may include a second redistribution structure, a bridge die on an upper surface of the second redistribution structure, a first molding material disposed on the upper surface of the second redistribution structure and configured to cover the bridge die disposed on the upper surface of the second redistribution structure, a plurality of connection structures disposed on a lower surface of the second redistribution structure and connected to the first redistribution structure, a third redistribution structure on the first molding material and on the bridge die, a first semiconductor die on the third redistribution structure, a second semiconductor die on the third redistribution structure, and beside the first semiconductor die, where the second semiconductor die is electrically connected to the first semiconductor die through the bridge die, and a second molding material configured to cover the first semiconductor die and the second semiconductor die, on the third redistribution structure, and a third molding material configured to cover the sub-semiconductor package, on the first redistribution structure.

According to an aspect of the present disclosure, a semiconductor package may include a first redistribution structure, a sub-semiconductor package on the first redistribution structure, where the sub-semiconductor package may include a second redistribution structure, a bridge die on the second redistribution structure, a plurality of first connection members on the second redistribution structure and beside the bridge die, a first molding material disposed on the second redistribution structure and configured to cover the bridge die and the plurality of first connection members, a third redistribution structure disposed on the first molding material, the bridge die, and the plurality of first connection members, a first semiconductor die disposed on the third redistribution structure, a second semiconductor die disposed on the third redistribution structure, and beside the first semiconductor die, where the second semiconductor die is electrically connected to the first semiconductor die through the bridge die, and a second molding material disposed on the third redistribution structure and configured to cover the first semiconductor die and the second semiconductor die, a plurality of second connection members disposed on the first redistribution structure, a third molding material disposed on the first redistribution structure and configured to cover a sub-semiconductor package and the plurality of second connection members, a fourth redistribution structure disposed on the third molding material and the plurality of second connection members, and a third semiconductor die disposed on the fourth redistribution structure.

A semiconductor package may include a first redistribution structure, a sub-semiconductor package on the first redistribution structure, where the sub-semiconductor package may include a second redistribution structure, a bridge die on the second redistribution structure, a plurality of first connection members on the second redistribution structure, a first molding material disposed on the second redistribution structure and configured to cover the bridge die and the plurality of first connection members, a third redistribution structure disposed on the first molding material, the bridge die, and the plurality of first connection members, a first semiconductor die disposed on the third redistribution structure, a second semiconductor die disposed on the third redistribution structure, and beside the first semiconductor die, where the second semiconductor die is electrically connected to the first semiconductor die through the bridge die, and a second molding material disposed on the third redistribution structure and configured to cover the first semiconductor die and the second semiconductor die, a third semiconductor die on the first redistribution structure and beside the sub-semiconductor package, and a third molding material disposed on the first redistribution structure and configured to cover the sub-semiconductor package and the third semiconductor die.

The bridge die and the passive element die may be disposed in sub-semiconductor package, and may be covered by a molding material within the sub-semiconductor package and a molding material covering the sub-semiconductor package. Accordingly, the bridge die and the passive element die are not exposed to the outside and double-covered by molding materials, thereby being protected from the external environment.

The semiconductor dies and the passive element die may be disposed within sub-semiconductor package. Accordingly, by forming the distance between the semiconductor dies and the passive element die as a shortest distance, the power integrity (PI) of the semiconductor package may be improved.

The bridge die and the passive element die may be positioned within a sub-semiconductor package. As a result, connection bumps can be placed in areas previously unavailable due to the space occupied by the bridge die and surface mount device (SMD). This arrangement enables a design margin to be secured in the lower redistribution structure, facilitating the implementation of both signal transmission and power transfer paths.

The sub-semiconductor package including the semiconductor dies, the redistribution structure, the bridge die, and the passive element die may be applied to various platforms.

The bridge die and the passive element die may be disposed in sub-semiconductor package, and sub-semiconductor package may be disposed on the front-side redistribution structure. Accordingly, a routing path of the bridge die may not be formed in the front-side redistribution structure, thereby reducing the total number of layers of the front-side redistribution structure.

### BRIEF DESCRIPTION OF THE DRAWINGS

FIG. 1 is a cross-sectional view showing a sub-semiconductor package of an embodiment.
FIG. 2 to FIG. 11 are cross-sectional views for explaining a method of manufacturing a sub-semiconductor package of an embodiment of FIG. 1.
FIG. 12 is a cross-sectional view showing a sub-semiconductor package of an embodiment.
FIG. 13 to 23 are cross-sectional views for explaining a method of manufacturing a sub-semiconductor package of an embodiment of FIG. 12.
FIG. 24 is a cross-sectional view showing a semiconductor package of an embodiment.
FIG. 25 is a cross-sectional view showing a semiconductor package of an embodiment.
FIG. 26 is a top plan view showing a top surface of a semiconductor package of an embodiment of FIG. 25.
FIG. 27 is a cross-sectional view showing a semiconductor package of an embodiment.

### DETAILED DESCRIPTION OF THE EMBODIMENTS

The present disclosure will be described more fully hereinafter with reference to the accompanying drawings, in which embodiments of the disclosure are shown. As those skilled in the art would realize, the described embodiments may be modified in various different ways, all without departing from the scope of the present disclosure.

The drawings and description are to be regarded as illustrative in nature and not restrictive. Like reference numerals designate like elements throughout the specification.

Further, in the drawings, the size and thickness of each element are arbitrarily illustrated for ease of description, and the present disclosure is not necessarily limited to those illustrated in the drawings.

Throughout this specification and the claims that follow, when it is described that an element is "coupled or connected" to another element, the element may be "directly coupled or connected" to the other element or "indirectly coupled or connected" to the other element through a third element. Unless explicitly described to the contrary, the word "comprise" and variations such as "comprises" or "comprising" will be understood to imply the inclusion of stated elements but not the exclusion of any other elements.

It will be understood that when an element such as a layer, film, region, area, or substrate is referred to as being "on" another element, it can be directly on the other element or intervening elements may also be present. In contrast, when an element is referred to as being "directly on" another element, there are no intervening elements present. Further, in the specification, the word "on" or "above" means positioned on or below the object portion, and does not necessarily mean positioned on the upper side of the object portion based on a gravitational direction.

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

Hereinafter, sub-semiconductor packages 100A and 100B, a manufacturing method of the sub-semiconductor packages 100A and 100B, and semiconductor packages 200A, 200B, and 200C, of embodiments, will be described with reference to the drawings.

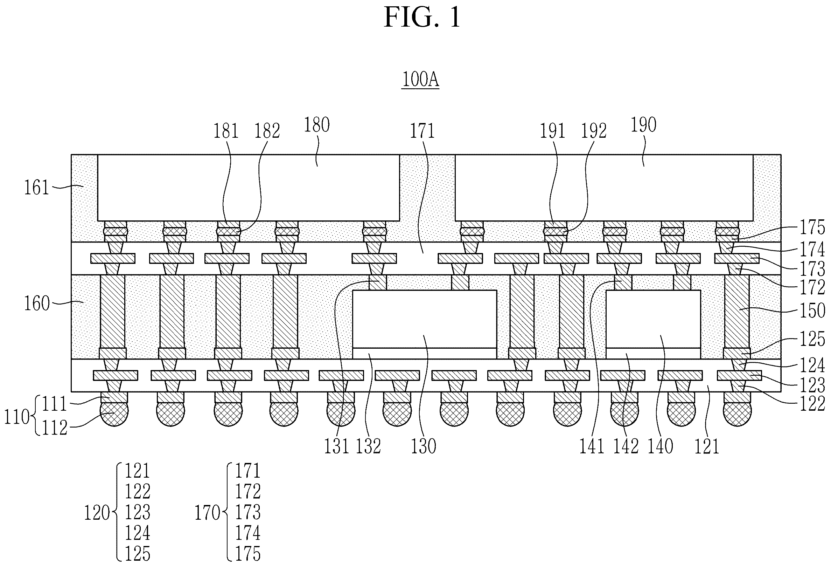

FIG. 1 is a cross-sectional view showing the sub-semiconductor package 100A of an embodiment.

Referring to FIG. 1, the sub-semiconductor package 100A may include a connection structure 110, lower redistribution structure (second redistribution structure) 120, a bridge die 130, a passive element die 140, first connection members 150, a first molding material 160, upper redistribution structure (third redistribution structure) 170, a first semiconductor die 180, a second semiconductor die 190, and a second molding material 161. In an embodiment, the sub-semiconductor package 100A may include a system-in-package (SIP). The sub-semiconductor package 100A implements two or more processor dies as one semiconductor package, and may operate as one chip. In an embodiment, the sub-semiconductor package 100A may be a semiconductor package manufactured by a chip (die) last process. In an embodiment, the sub-semiconductor package 100A may be manufactured based on the fan-out wafer level package (FOWLP) or fan-out panel level package (FOPLP) technology.

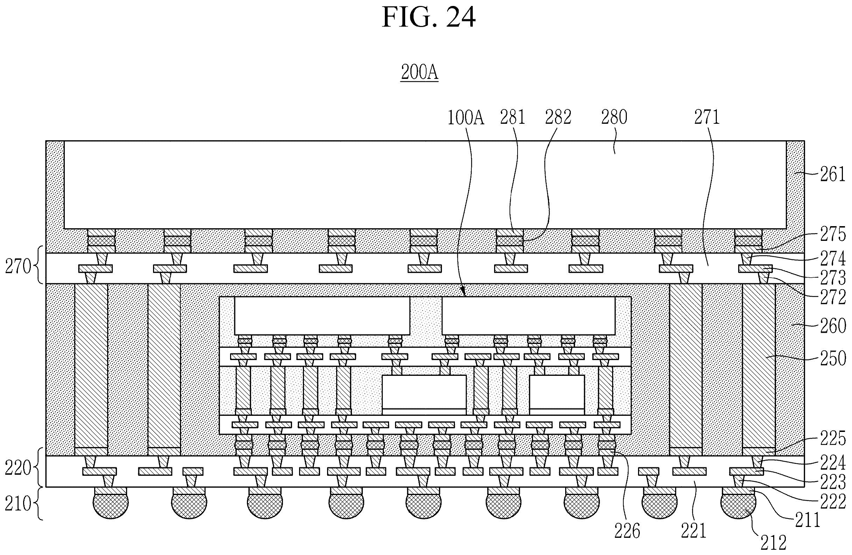

The connection structure 110 may be disposed on a bottom surface of the lower redistribution structure 120. The connection structure 110 may include conductive pads 111 and connection bumps 112. Each of the conductive pads 111 may be disposed between each of the connection bumps 112 and each of a first redistribution vias 122 of the lower redistribution structure 120. Each of the conductive pads 111 may electrically connect each of the first redistribution vias 122 of the lower redistribution structure 120 to each of the connection bumps 112. Each of the connection bumps 112 may be disposed under each of the conductive pads 111. Referring to FIG. 24, FIG. 25 and FIG. 27, the connection bumps 112 may electrically connect the sub-semiconductor package 100A to a front-side redistribution structure 220 of a semiconductor package 200A, 200B, or 200C.

The lower redistribution structure 120 may be disposed on the connection structure 110. The lower redistribution structure 120 may include a first dielectric material 121, the first redistribution vias 122, first redistribution lines 123 and a second redistribution vias 124 within the first dielectric material 121, and first bonding pads 125 on the first dielectric material 121. In another embodiment, the lower redistribution structure 120 including a smaller or larger number of redistribution lines, redistribution vias, and bonding pads may be included in the scope of the present disclosure.

The first dielectric material 121 may protect and insulate the first redistribution vias 122, the first redistribution lines 123, and the second redistribution vias 124. The first bonding pads 125, a first adhesive member 132, a second adhesive member 142, and the first molding material 160 may be disposed on a top surface of the first dielectric material 121. The connection structure 110 may be disposed on a bottom surface of the first dielectric material 121.

Each of the first redistribution vias 122 may be disposed betweenone of the first redistribution lines 123 and one of the conductive pads 111. Each of the first redistribution vias 122 may electrically connect one of the first redistribution lines 123 to one of the conductive pads 111, in a vertical direction. Each of the first redistribution lines 123 may be disposed between one of the first redistribution vias 122 and one of the second redistribution vias 124. Each of the first redistribution lines 123 may electrically connect each of the second redistribution vias 124 to one of the first redistribution vias 122, in a horizontal direction. Each of the second redistribution vias 124 may be disposed between one of the first redistribution lines 123 and one of the first bonding pads 125. Each of the second redistribution vias 124 may electrically connect one of the first bonding pads 125 to one of the first redistribution lines 123, in the vertical direction. Each of the first bonding pads 125 may be disposed between one of the second redistribution vias 124 and one of the first connection members 150. Each of the first bonding pads 125 may electrically connect one of the first connection members 150 to one of the second redistribution vias 124, in the vertical direction. Each of the first redistribution vias 122 and the second redistribution vias 124 may have a shape in which the width increases from the bottom to the top.

The bridge die 130 may be disposed on the lower redistribution structure 120. In an embodiment, the bridge die 130 may include a silicon bridge die. The bridge die 130 may electrically connect the first semiconductor die 180 to the second semiconductor die 190 through an upper redistribution structure 170. In some embodiments, the first semiconductor die 180 and the second semiconductor die 190 may be heterogeneous devices (i.e., different kind of devices), and the bridge die 130 may provide connections therebetween. Signals between the first semiconductor die 180 and the second semiconductor die 190 may be routed through the bridge die 130. The bridge die 130 may be attached on the lower redistribution structure 120 by the first adhesive member 132. The first adhesive member 132 may be attached on a top surface of the lower redistribution structure 120, and the bridge die 130 may be attached on the first adhesive member 132. The bridge die 130 may be connected to the upper redistribution structure 170 through first connection terminals 131. Each of the first connection terminals 131 may be disposed between the bridge die 130 and one of third redistribution vias 172 of the upper redistribution structure 170. Each of the first connection terminals 131 may electrically connect one of the third redistribution vias 172 of the upper redistribution structure 170 to the bridge die 130 in the vertical direction.

The passive element die 140 may be disposed on the lower redistribution structure 120. The passive element die 140 may be disposed between external connection members in conventional semiconductor package, and may be a configuration corresponding to a surface mount device (SMD) exposed to the outside together with the external connection members. The passive element die 140 may be included within the sub-semiconductor package 100A and may be provided in plural. The passive element die 140 may be electrically connected to the first semiconductor die 180 and the second semiconductor die 190 through the upper redistribution structure 170. In an embodiment, the passive element die 140 may provide additional functionality or programming to the entire sub-semiconductor package 100A. In an embodiment, the passive element die 140 may include a resistor, an inductor, a capacitor, or a jumper. In an embodiment, the passive element die 140 may include an integrated stack capacitor (ISC). In an embodiment, the passive element die 140 may function as a decoupling capacitor. When the passive element die 140 functions as a decoupling capacitor, the passive element die 140 may protect the first semiconductor die 180 and the second semiconductor die 190 from the noise during the process of transmitting power.

The passive element die 140 may be attached on the lower redistribution structure 120 by the second adhesive member 142. The second adhesive member 142 may be attached on the top surface of the lower redistribution structure 120, and the passive element die 140 may be attached on the second adhesive member 142. The passive element die 140 may be connected to the upper redistribution structure 170 through second connection terminals 141. Each of the second connection terminals 141 may be disposed between the passive element die 140 and one of the third redistribution vias 172 of the upper redistribution structure 170. Each of the second connection terminals 141 may electrically connect one of the third redistribution vias 172 of the upper redistribution structure 170 to the passive element die 140 in the vertical direction.

In conventional designs, the bridge die and a surface mount device (SMD) were positioned side by side with the connection bumps, occupying space required for the connection bumps. However, in this disclosure, the bridge die 130 and the passive element die 140 are integrated within the sub-semiconductor package 100A. This arrangement allows the connection bumps to be placed in areas previously occupied by the conventional bridge die and the SMD, enabling additional design margin for implementing signal transmission and power transfer paths within the redistribution structures of the semiconductor package 200A. In some embodiments, the bridge die 130 and the passive element die 140 may vertically overlap some of the connection bumps.

The first connection members 150 may be disposed on the lower redistribution structure 120. In an embodiment, the first connection members 150 may include conductive posts. The first connection members 150 may be disposed around the bridge die 130, and around the passive element die 140. In some embodiments, the first connection members 150 may surround each of the bridge die 130 and the passive element die 140 when viewed in a plan view. The first connection members 150 may be disposed beside the bridge die 130, and beside the passive element die 140. Each of the first connection members 150 may be disposed between one of the first bonding pads 125 of the lower redistribution structure 120 and one of the third redistribution vias 172 of the upper redistribution structure 170. Each of the first connection members 150 may electrically connect one of the third redistribution vias 172 of the upper redistribution structure 170 to one of the first bonding pads 125 of the lower redistribution structure 120. The first connection members 150 may be disposed to penetrate the first molding material 160. A side surface of the first connection members 150 may be surrounded by the first molding material 160.

The first molding material 160 may be disposed on the lower redistribution structure 120, and cover the first bonding pads 125, the bridge die 130, the first connection terminals 131, the first adhesive member 132, the passive element die 140, the second connection terminals 141, and the second adhesive member 142. The first molding material 160 may protect the first bonding pads 125, the bridge die 130, the first connection terminals 131, the first adhesive member 132, the passive element die 140, the second connection terminals 141, and the second adhesive member 142 from the external environment.

The upper redistribution structure 170 may be disposed on the first connection terminals 131, the second connection terminals 141, the first connection members 150, and the first molding material 160. The upper redistribution structure 170 may include a second dielectric material 171, the third redistribution vias 172, second redistribution lines 173 and a fourth redistribution vias 174 within the second dielectric material 171, and second bonding pads 175 on the second dielectric material 171. In another embodiment, the upper redistribution structure 170 including a smaller or larger number of redistribution lines, redistribution vias, and bonding pads may be included in the scope of the present disclosure.

The second dielectric material 171 may protect and insulate the third redistribution vias 172, the second redistribution lines 173, and the fourth redistribution vias 174. The second bonding pads 175 and the second molding material 161 may be disposed on a top surface of the second dielectric material 171. The first connection terminals 131, the second connection terminals 141, the first connection members 150, and the first molding material 160 may be disposed on a bottom surface of the second dielectric material 171.

Each of the third redistribution vias 172 may be disposed between one of the first connection terminals 131 and one of the second redistribution lines 173, between one of the second connection terminals 141 and one of the second redistribution lines 173, or between one of the first connection members 150 and one of the second redistribution lines 173. Each of the third redistribution vias 172 may electrically connect one of the second redistribution lines 173 to one of the first connection terminals 131, one of the second redistribution lines 173 to one of the second connection terminals 141, or one of the second redistribution lines 173 to one of the first connection members 150. Each of the second redistribution lines 173 may be disposed between one of the third redistribution vias 172 and one of the fourth redistribution vias 174. Each of the second redistribution lines 173 may electrically connect one of the fourth redistribution vias 174 to one of the third redistribution vias 172, in the horizontal direction. Each of the fourth redistribution vias 174 may be between one of the second redistribution lines 173 and one of the second bonding pads 175. Each of the fourth redistribution vias 174 may electrically connect one of the second bonding pads 175 to one of the second redistribution lines 173, in the vertical direction. Each of the second bonding pads 175 may be disposed between one of the fourth redistribution vias 174 and one of first connection bumps 182, or between one of the fourth redistribution vias 174 and one of second connection bumps 192. Each of the second bonding pads 175 may electrically connect one of the first connection bumps 182 to one of the fourth redistribution vias 174, or one of the second connection bumps 192 to one of the fourth redistribution vias 174, in the vertical direction. Each of the third redistribution vias 172 and the fourth redistribution vias 174 may have a shape in which the width increases from the bottom to the top.

The first semiconductor die 180 may be disposed on the upper redistribution structure 170. The first semiconductor die 180 may be disposed side by side with the second semiconductor die 190. In an embodiment, the first semiconductor die 180 may include an application processor (AP). The first semiconductor die 180 may be a chiplet manufactured by dividing the application processor (AP) according to the intended use, or the applied process. In some embodiments, the first die 180 may be a chiplet corresponding to at least one functional block of the AP. In an embodiment, the first semiconductor die 180 may include at least one of a central processing unit (CPU), a graphics processing unit (GPU), a signal processor, a network processor, and a codec.

Each of first connection pads 181 may be disposed between one of wires of the first semiconductor die 180 and one of the first connection bumps 182. Each of the first connection pads 181 may electrically connect one of wires of the first semiconductor die 180 to one of the first connection bumps 182.

Each of the first connection bumps 182 may be disposed between one of the first connection pads 181 and one of the second bonding pads 175. Each of the first connection bumps 182 may electrically connect one of the first connection pads 181 to one of the second bonding pads 175.

The second semiconductor die 190 may be disposed on the upper redistribution structure 170. The second semiconductor die 190 may be disposed side by side with the first semiconductor die 180. In an embodiment, the second semiconductor die 190 may include the application processor (AP). The second semiconductor die 190 may be a chiplet manufactured by dividing the application processor (AP) according to the intended use, or the applied process. In some embodiments, the second die 190 may be a chiplet corresponding to at least one functional block of the AP. In an embodiment, the second semiconductor die 190 may include at least one of a central processing unit (CPU), a graphics processing unit (GPU), a signal processor, a network processor, and a codec.

Each of second connection pads 191 may be disposed between one of wires of the second semiconductor die 190 and one of the second connection bumps 192. Each of the second connection pads 191 may electrically connect one of wires of the second semiconductor die 190 to one of the second connection bumps 192. Each of the second connection bumps 192 may be disposed between one of the second connection pads 191 and one of the second bonding pads 175. Each of the second connection bumps 192 may electrically connect one of the second connection pads 191 to one of the second bonding pads 175.

According to the present disclosure, the sub-semiconductor package 100A including the passive element die 140, the first semiconductor die 180, and the second semiconductor die 190 may be provided. Accordingly, by forming a distance between the passive element die 140 and the first semiconductor die 180, and a distance between the passive element die 140 and the second semiconductor die 190, as a shortest distance, the power integrity (PI) of the semiconductor package 200A may be improved. For example, by minimizing the distance between the passive element die 140 and both the first semiconductor die 180 and the second semiconductor die 190, the power integrity (PI) of the semiconductor package 200A can be enhanced.

The second molding material 161 may be disposed on the upper redistribution structure 170 and cover the second bonding pads 175, the first semiconductor die 180, the first connection pads 181, the first connection bumps 182, the second semiconductor die 190, the second connection pads 191, and the second connection bumps 192. The second molding material 161 may protect the second bonding pads 175, the first semiconductor die 180, the first connection pads 181, the first connection bumps 182, the second semiconductor die 190, the second connection pads 191, and the second connection bumps 192 from the external environment. A top surface of the first semiconductor die 180, and a top surface of the second semiconductor die 190 may be exposed to the outside from the second molding material 161.

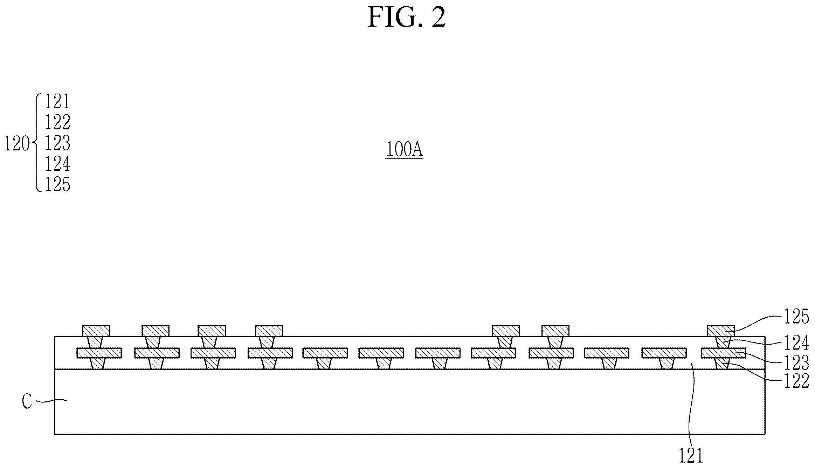

FIG. 2 to FIG. 11 are cross-sectional views for explaining a method of manufacturing the sub-semiconductor package 100A of an embodiment of FIG. 1. FIG. 2 to FIG. 11 are cross-sectional views showing a method of manufacturing a sub-semiconductor package 100B that applies a chip last process.

FIG. 2 is a cross-sectional view showing the step of forming the lower redistribution structure 120 on a carrier C.

Referring to FIG. 2, the lower redistribution structure 120 may be formed on the carrier C. First, the carrier C may be provided. In an embodiment, the carrier C may include a silicon-based material such as glass and silicon oxide, another material such as organic material and aluminum oxide, or any combination of these materials.

Then, the first dielectric material 121 may be formed on the carrier C. In an embodiment, the first dielectric material 121 may include photoimageable dielectrics (PID) used in a redistribution layer process. As an embodiment, photoimageable dielectrics (PID) may include polyimide-based photoactive polymer, novolac-based photoactive polymer, polybenzoxazole, silicone-based polymer, acrylate-based polymer, or epoxy-based polymer. In an embodiment, the first dielectric material 121 may be formed by performing a spin coating process.

After forming the first dielectric material 121, via holes may be formed by selectively etching the first dielectric material 121, and the first redistribution vias 122 may be formed by filling a conducting material into the via holes. After forming the first redistribution vias 122, the first dielectric material 121 may be additionally formed on the first redistribution vias 122 and the first dielectric material 121, openings may be formed by selectively etching the additionally formed first dielectric material 121, and the first redistribution lines 123 may be formed by filling a conducting material in the openings. After forming the first redistribution lines 123, the first dielectric material 121 may be additionally formed on the first redistribution lines 123 and the first dielectric material 121, via holes may be formed by selectively etching the additionally formed first dielectric material 121, and the second redistribution vias 124 may be formed by filling a conducting material into the via holes. After forming the second redistribution vias 124, photoresist may be additionally deposited on the second redistribution vias 124 and the first dielectric material 121, a photoresist pattern including via holes may be formed by selectively exposing and developing the photoresist, and the first bonding pads 125 may be formed by filling a conducting material into the via holes. In the sub-semiconductor package 100A of an embodiment manufactured by the chip last process, each of the first redistribution vias 122 and the second redistribution vias 124 may have a shape in which the width increases from the bottom to the top.

In an embodiment, each of the first redistribution vias 122, the first redistribution lines 123, the second redistribution vias 124, and the first bonding pads 125 may include at least one of copper, aluminum, tungsten, nickel, gold, tin, titanium, and an alloy thereof. In an embodiment, the first redistribution vias 122, the first redistribution lines 123, the second redistribution vias 124, and the first bonding pads 125 may be formed by performing a sputtering process. In another embodiment, each of the first redistribution vias 122, the first redistribution lines 123, the second redistribution vias 124, and the first bonding pads 125 may be formed by performing an electroplating process after forming a seed metal layer.

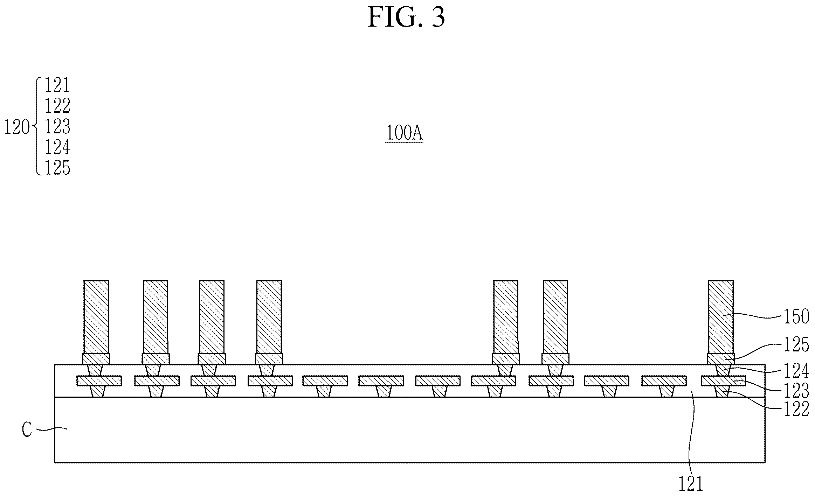

FIG. 3 is a cross-sectional view showing the step of forming the first connection members 150 on the lower redistribution structure 120.

Referring to FIG. 3, the first connection members 150 may be formed on the first bonding pads 125 of the lower redistribution structure 120. In an embodiment, the first connection members 150 may be formed by performing a sputtering process. In another embodiment, the first connection members 150 may be formed by performing an electroplating process after forming a seed metal layer. In an embodiment, the first connection members 150 may include at least one of copper, aluminum, tungsten, nickel, gold, silver, chromium, antimony, tin, titanium, and an alloy thereof.

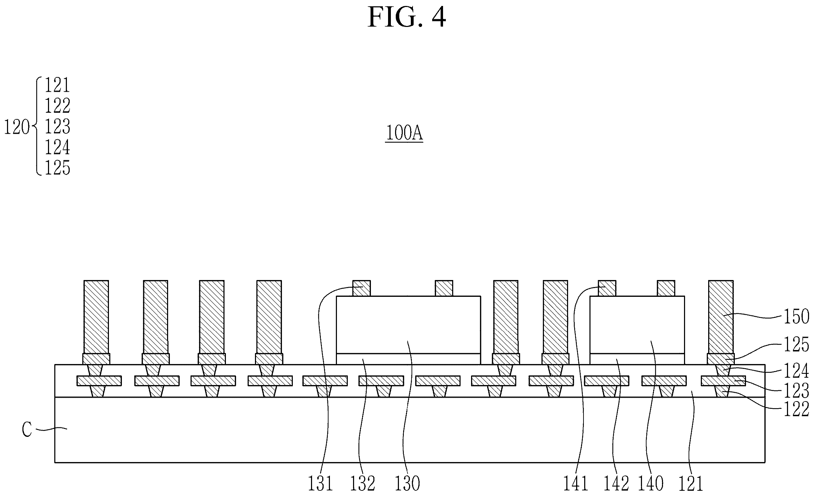

FIG. 4 is a cross-sectional view showing the step of attaching the bridge die 130 and the passive element die 140 on the lower redistribution structure 120.

Referring to FIG. 4, the bridge die 130 and the passive element die 140 may be attached on the lower redistribution structure 120. The bridge die 130 may be attached onto the lower redistribution structure 120 by the first adhesive member 132, and may be physically fixed to the lower redistribution structure 120. In an embodiment, the first adhesive member 132 may include a die-attach film (DAF). The passive element die 140 may be attached onto the lower redistribution structure 120 by the second adhesive member 142, and may be physically fixed to the lower redistribution structure 120. In an embodiment, the second adhesive member 142 may include a die-attach film (DAF).

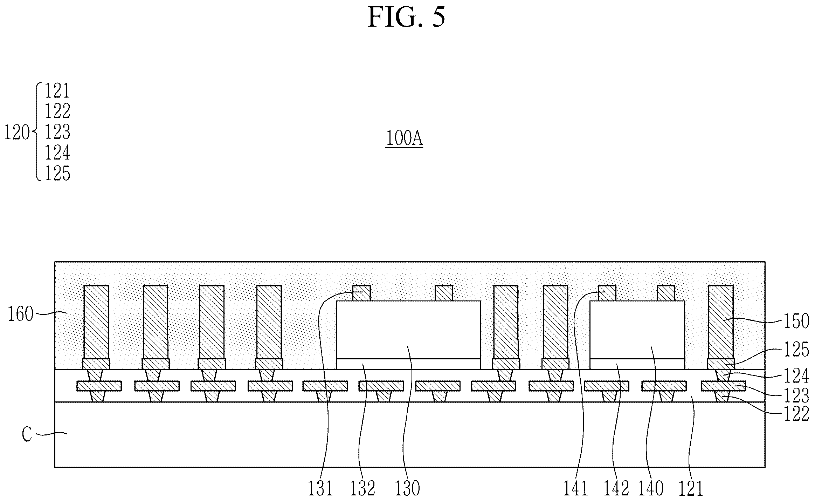

FIG. 5 is a cross-sectional view showing the step of molding the bridge die 130, the first connection terminals 131, the passive element die 140, the second connection terminals 141, and the first connection members 150 which are disposed on the lower redistribution structure 120.

Referring to FIG. 5, the bridge die 130, the first connection terminals 131, the passive element die 140, the second connection terminals 141, and the first connection members 150 may be molded using the first molding material 160. For example, the first molding material 160 may be disposed on the lower redistribution structure 120 and cover the bridge die 130, the first connection terminals 131, the passive element die 140, the second connection terminals 141, and the first connection members 150. As an embodiment, the process of molding the first molding material 160 may include a compression molding or transfer molding process. In an embodiment, the first molding material 160 may include an epoxy molding compound (EMC).

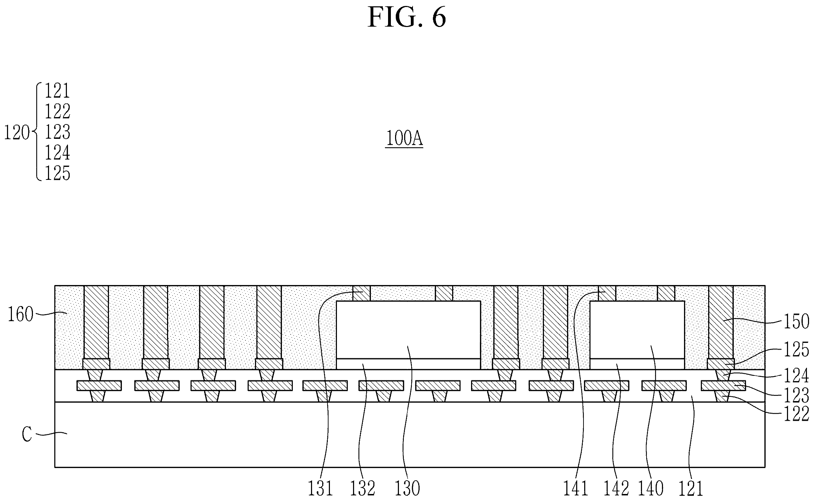

FIG. 6 is a cross-sectional view showing the step of performing a chemical mechanical planarization (CMP) process on the first molding material 160.

Referring to FIG. 6, in order to level a top surface of the first molding material 160, the top surface of the first molding material 160 may be planarized by performing a chemical mechanical planarization (CMP) process. After performing a chemical mechanical planarization (CMP) process, a top surface of the first connection terminals 131, a top surface of the second connection terminals 141, and a top surface of the first connection members 150 may be exposed.

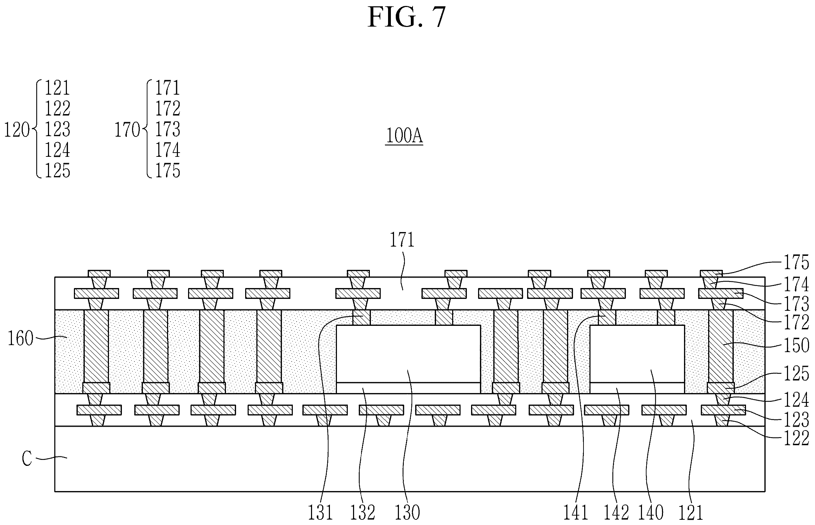

FIG. 7 is a cross-sectional view showing the step of forming the upper redistribution structure 170 on the first connection terminals 131, the second connection terminals 141, the first connection members 150, and the first molding material 160.

Referring to FIG. 7, the second dielectric material 171 may be formed on the first connection terminals 131, the second connection terminals 141, the first connection members 150, and the first molding material 160. In an embodiment, the second dielectric material 171 may include photoimageable dielectrics (PID) used in a redistribution layer process. In an embodiment, the second dielectric material 171 may be formed by performing a spin coating process.

After forming the second dielectric material 171, via holes may be formed by selectively etching the second dielectric material 171, and the third redistribution vias 172 may be formed by filling a conducting material into the via holes. After forming the third redistribution vias 172, the second dielectric material 171 may be additionally formed on the third redistribution vias 172 and the second dielectric material 171, openings may be formed by selectively etching the additionally formed second dielectric material 171, and the second redistribution lines 173 may be formed by filling a conducting material into the openings. After forming the second redistribution lines 173, the second dielectric material 171 may be additionally formed on the second redistribution lines 173 and the second dielectric material 171, via holes may be formed by selectively etching the additionally formed second dielectric material 171, and the fourth redistribution vias 174 may be formed by filling a conducting material into the via holes. After forming the fourth redistribution vias 174, photoresist may be additionally deposited on the fourth redistribution vias 174 and the second dielectric material 171, a photoresist pattern including via holes may be formed by selectively exposing and developing the photoresist, and the second bonding pads 175 may be formed by filling a conducting material into the via holes.

In an embodiment, each of the third redistribution vias 172, the second redistribution lines 173, the fourth redistribution vias 174, and the second bonding pads 175 may include at least one of copper, aluminum, tungsten, nickel, gold, tin, titanium, and an alloy thereof. In an embodiment, each of the third redistribution vias 172, the second redistribution lines 173, the fourth redistribution vias 174, and the second bonding pads 175 may be formed by performing a sputtering process. In another embodiment, each of the third redistribution vias 172, the second redistribution lines 173, the fourth redistribution vias 174, and the second bonding pads 175 may be formed by performing an electroplating process after forming a seed metal layer.

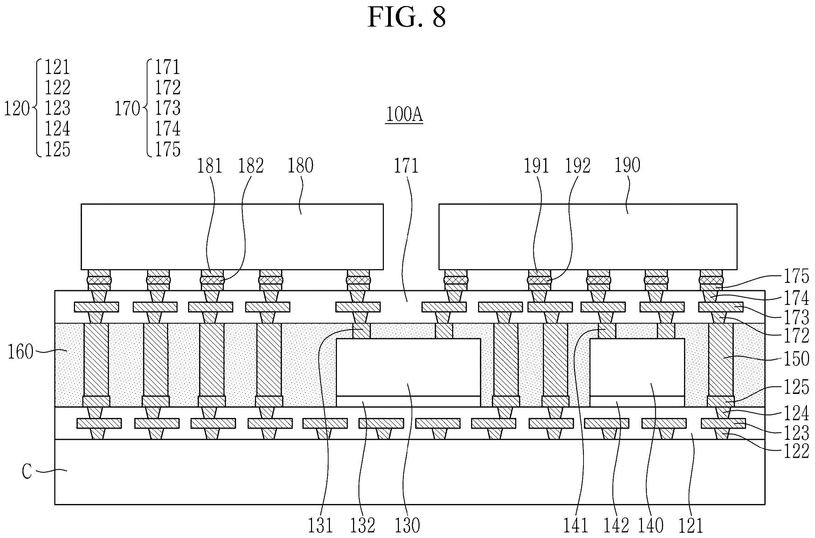

FIG. 8 is a cross-sectional view showing the step of mounting the first semiconductor die 180 and the second semiconductor die 190 onto the upper redistribution structure 170.

Referring to FIG. 8, the first semiconductor die 180 and the second semiconductor die 190 may be mounted onto the upper redistribution structure 170. In an embodiment, each of the first semiconductor die 180 and the second semiconductor die 190 may be bonded onto the upper redistribution structure 170 by performing a flip chip bonding process. The first semiconductor die 180 may be bonded to the second bonding pads 175 of the upper redistribution structure 170 by the first connection bumps 182, and the second semiconductor die 190 may be bonded to the second bonding pads 175 of the upper redistribution structure 170 by the second connection bumps 192. The first semiconductor die 180 and the upper redistribution structure 170 may be electrically connected to each other, and the second semiconductor die 190 and the upper redistribution structure 170 may be electrically connected to each other. In an embodiment, each of the first connection bumps 182 and the second connection bumps 192 may include at least one of tin, silver, lead, nickel, copper, and an alloy thereof.

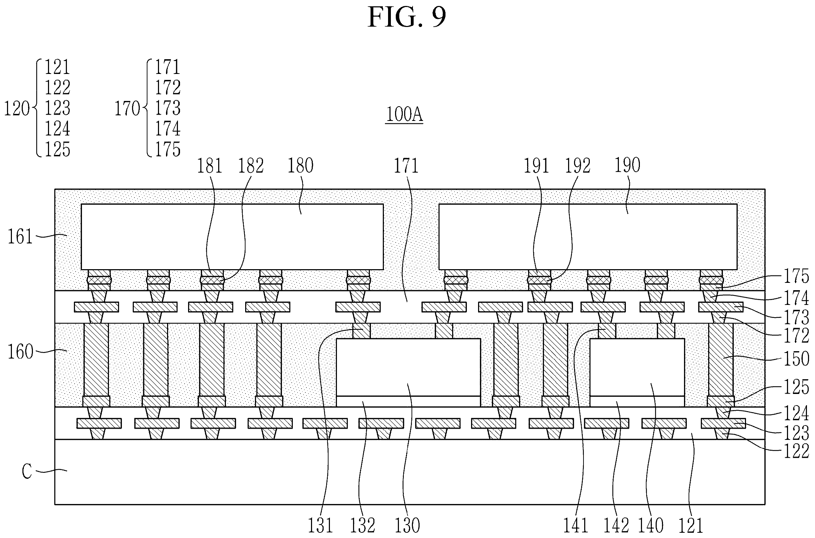

FIG. 9 is a cross-sectional view showing the step of molding the first semiconductor die 180, the first connection pads 181, the first connection bumps 182, the second semiconductor die 190, the second connection pads 191, and the second connection bumps 192 which are disposed on the upper redistribution structure 170.

Referring to FIG. 9, the first semiconductor die 180, the first connection pads 181, the first connection bumps 182, the second semiconductor die 190, the second connection pads 191, and the second connection bumps 192 may be molded by the second molding material 161. For example, the second molding material 161 may be disposed on the upper redistribution structure 170 and cover the first semiconductor die 180, the first connection pads 181, the first connection bumps 182, the second semiconductor die 190, the second connection pads 191, and the second connection bumps 192. As an embodiment, the process of molding the second molding material 161 may include a compression molding or transfer molding process. In an embodiment, the second molding material 161 may include an epoxy molding compound (EMC).

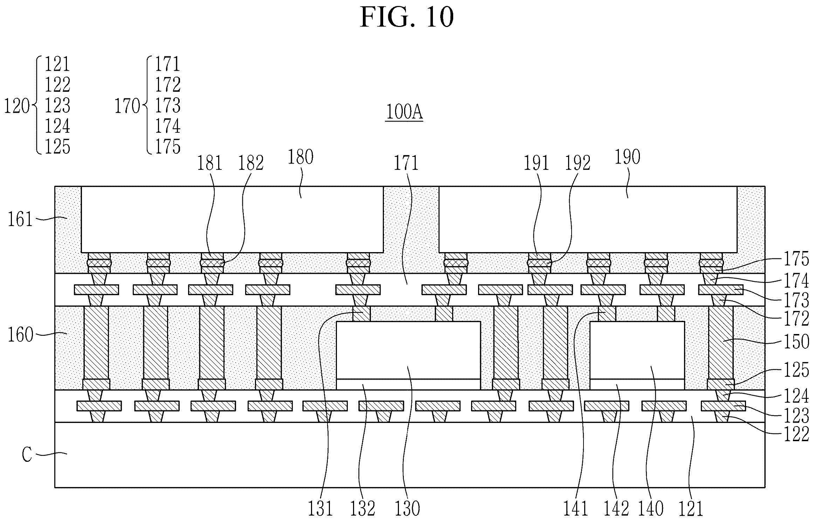

FIG. 10 is a cross-sectional view showing the step of performing a chemical mechanical planarization (CMP) process on the second molding material 161.

Referring to FIG. 10, in order to level a top surface of the second molding material 161, the top surface of the second molding material 161 may be planarized by performing a chemical mechanical planarization (CMP) process. After performing a chemical mechanical planarization (CMP) process, the top surface of the first semiconductor die 180 and the top surface of the second semiconductor die 190 may be exposed.

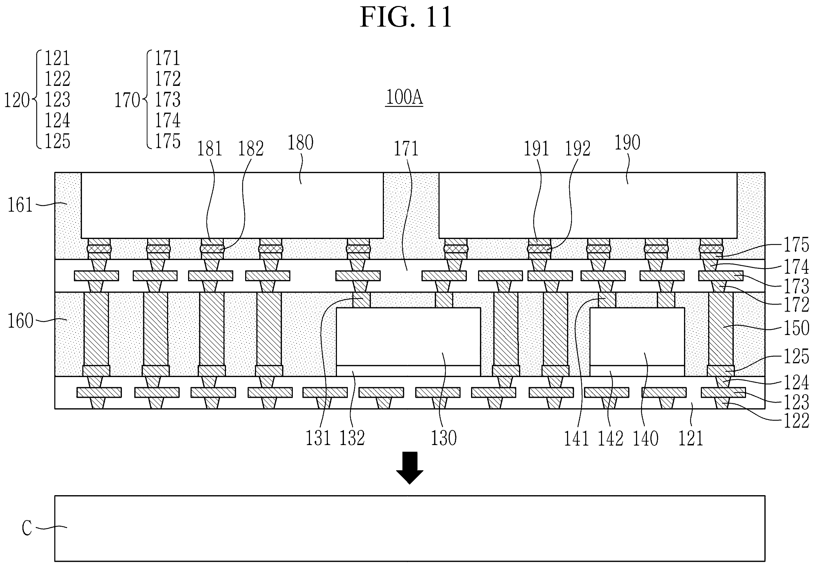

FIG. 11 is a cross-sectional view showing the step of removing the carrier C from the lower redistribution structure 120.

Referring to FIG. 11, the carrier C may be removed from a bottom surface of the lower redistribution structure 120. Thereafter, as shown in FIG. 1, the connection structure 110 may be formed on the bottom surface of the lower redistribution structure 120. The conductive pads 111 may be formed below the first redistribution vias 122 of the lower redistribution structure 120. In an embodiment, the conductive pads 111 may include at least one of copper, nickel, zinc, gold, silver, platinum, palladium, chromium, titanium, and an alloy thereof. In an embodiment, the conductive pads 111 may be formed by a sputtering process or by performing an electroplating process after forming a seed metal layer. Thereafter, the connection bumps 112 may be formed below the conductive pads 111. In an embodiment, the connection bumps 112 may include at least one of tin, silver, lead, nickel, copper, and an alloy thereof.

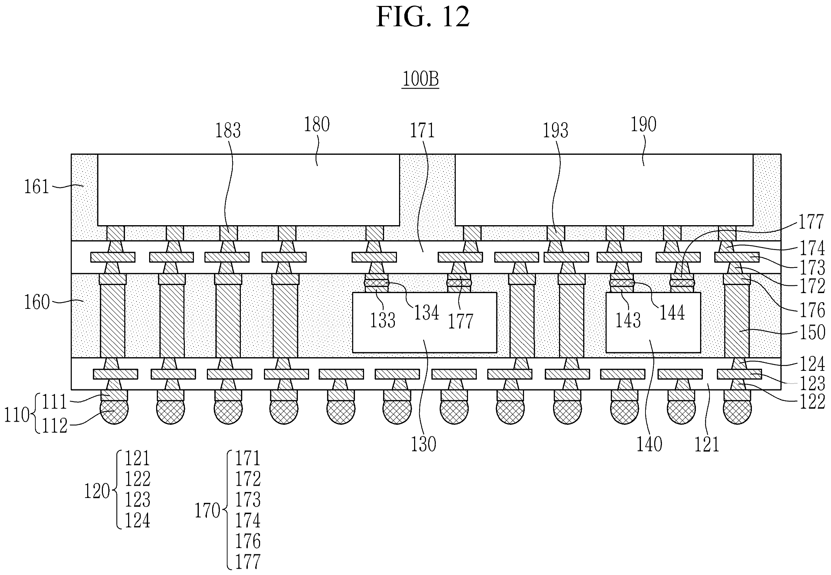

FIG. 12 is a cross-sectional view showing the sub-semiconductor package 100B of an embodiment.

Referring to FIG. 12, the sub-semiconductor package 100B may include the connection structure 110, the lower redistribution structure 120, the bridge die 130, the passive element die 140, the first connection members 150, the first molding material 160, the upper redistribution structure 170, the first semiconductor die 180, the second semiconductor die 190, and the second molding material 161. In an embodiment, the sub-semiconductor package 100B may include a system-in-package (SIP). The sub-semiconductor package 100B implements two or more processor dies as one semiconductor package, and may operate as one chip. In an embodiment, the sub-semiconductor package 100B may be a semiconductor package manufactured by a chip (die) first process. In an embodiment, the sub-semiconductor package 100B may be manufactured based on the fan-out wafer level package (FOWLP) or fan-out panel level package (FOPLP) technology.

The lower redistribution structure 120 may include the first dielectric material 121, the first redistribution vias 122, the first redistribution lines 123 and the second redistribution vias 124 within the first dielectric material 121. In another embodiment, the lower redistribution structure 120 including a smaller or larger number of redistribution lines and redistribution vias may be included in the scope of the present disclosure. The first connection members 150 and the first molding material 160 may be disposed on the top surface of the first dielectric material 121. Each of the first redistribution vias 122 and the second redistribution vias 124 may have a shape in which the width decreases from the bottom to the top.

The bridge die 130 may be disposed on the lower redistribution structure 120. The bridge die 130 may be located to be spaced apart from the lower redistribution structure 120. The first molding material 160 may be filled between the bridge die 130 and the lower redistribution structure 120. The bridge die 130 may be connected to the upper redistribution structure 170 through third connection pads 133, third connection bumps 134, and fourth bonding pads 177. Each of the third connection pads 133 may be disposed between the bridge die 130 and one of the third connection bumps 134. Each of the third connection pads 133 may electrically connect one of the third connection bumps 134 to the bridge die 130, in the vertical direction. Each of the third connection bumps 134 may be disposed between one of the third connection pads 133 and one of the fourth bonding pads 177. Each of the third connection bumps 134 may electrically connect one of the fourth bonding pads 177 to one of the third connection pads 133. Each of the fourth bonding pads 177 connected to the bridge die 130 may be disposed between one of the third connection bumps 134 and one of the third redistribution vias 172 of the upper redistribution structure 170. Each of the fourth bonding pads 177 connected to the bridge die 130 may electrically connect one of the third redistribution vias 172 of the upper redistribution structure 170 to one of the third connection bumps 134.

The passive element die 140 may be disposed on the lower redistribution structure 120. The passive element die 140 may be located to be spaced apart from the lower redistribution structure 120. The first molding material 160 may be filled between the passive element die 140 and the lower redistribution structure 120. The passive element die 140 may be connected to the upper redistribution structure 170 through fourth connection pads 143, fourth connection bumps 144, and the fourth bonding pads 177. Each of the fourth connection pads 143 may be disposed between the passive element die 140 and one of the fourth connection bumps 144. Each of the fourth connection pads 143 may electrically connect one of the fourth connection bumps 144 to the passive element die 140, in the vertical direction. Each of the fourth connection bumps 144 may be disposed between one of the fourth connection pads 143 and one of the fourth bonding pads 177. Each of the fourth connection bumps 144 may electrically connect one of the fourth bonding pads 177 to one of the fourth connection pads 143. Each of the fourth bonding pads 177 connected to the passive element die 140 may be disposed between one of the fourth connection bumps 144 and one of the third redistribution vias 172 of the upper redistribution structure 170. Each of the fourth bonding pads 177 connected to the passive element die 140 may electrically connect one of the third redistribution vias 172 of the upper redistribution structure 170 to one of the fourth connection bumps 144.

Each of the first connection members 150 may be disposed between one of the second redistribution vias 124 of the lower redistribution structure 120 and one of third bonding pads 176 of the upper redistribution structure 170. Each of the first connection members 150 may electrically connect one of the third bonding pads 176 of the upper redistribution structure 170 to one of the second redistribution vias 124 of the lower redistribution structure 120.

The first molding material 160 may be disposed on the lower redistribution structure 120 and cover the bridge die 130, the third connection pads 133, the third connection bumps 134, the passive element die 140, the fourth connection pads 143, the fourth connection bumps 144, the first connection members 150, the third bonding pads 176, and the fourth bonding pads 177. The first molding material 160 may protect the bridge die 130, the third connection pads 133, the third connection bumps 134, the passive element die 140, the fourth connection pads 143, the fourth connection bumps 144, the first connection members 150, the third bonding pads 176, and the fourth bonding pads 177 from the external environment.

The upper redistribution structure 170 may be disposed on the first connection members 150 and the first molding material 160. The upper redistribution structure 170 may include the second dielectric material 171, the third redistribution vias 172, the second redistribution lines 173 and the fourth redistribution vias 174 within the second dielectric material 171, and the third bonding pads 176 and the fourth bonding pads 177 below the second dielectric material 171. In another embodiment, the upper redistribution structure 170 including a smaller or larger number of redistribution lines, redistribution vias, and bonding pads may be included in the scope of the present disclosure.

The second dielectric material 171 may protect and insulate the third redistribution vias 172, the second redistribution lines 173, and the fourth redistribution vias 174. Third connection terminals 183, fourth connection terminals 193, and the second molding material 161 may be disposed on the top surface of the second dielectric material 171. The third bonding pads 176, the fourth bonding pads 177, and the first molding material 160 may be disposed on the bottom surface of the second dielectric material 171.

Each of the third bonding pads 176 may be disposed between one of the first connection members 150 and one of the third redistribution vias 172. Each of the third bonding pads 176 may electrically connect one of the third redistribution vias 172 to one of the first connection members 150. Each of the fourth bonding pads 177 may be disposed between one of the third connection bumps 134 and one of the third redistribution vias 172, or between one of the fourth connection bumps 144 and one of the third redistribution vias 172. Each of the fourth bonding pads 177 may electrically connect one of the third redistribution vias 172 to one of the third connection bumps 134, or one of the third redistribution vias 172 to one of the fourth connection bumps 144. Each of the third redistribution vias 172 may be disposed between one of the third bonding pads 176 and one of the second redistribution lines 173, or between one of the fourth bonding pads 177 and one of the second redistribution lines 173. Each of the third redistribution vias 172 may electrically connect one of the second redistribution lines 173 to one of the third bonding pads 176, or one of the second redistribution lines 173 to one of the fourth bonding pads 177. Each of the second redistribution lines 173 may be disposed between one of the third redistribution vias 172 and one of the fourth redistribution vias 174. Each of the second redistribution lines 173 may electrically connect one of the fourth redistribution vias 174 to one of the third redistribution vias 172, in the horizontal direction. Each of the fourth redistribution vias 174 may be disposed between one of the second redistribution lines 173 and one of the third connection terminals 183, or between one of the second redistribution lines 173 and one of the fourth connection terminals 193. Each of the fourth redistribution vias 174 may electrically connect one of the third connection terminals 183 to one of the second redistribution lines 173, or one of the fourth connection terminals 193 to one of the second redistribution lines 173, in the vertical direction. Each of the third redistribution vias 172 and the fourth redistribution vias 174 may have a shape in which the width decreases from the bottom to the top.

Each of the third connection terminals 183 may be disposed between one of wires of the first semiconductor die 180 and one of the fourth redistribution vias 174. Each of the third connection terminals 183 may electrically connect one of wires of the first semiconductor die 180 to one of the fourth redistribution vias 174. Each of the fourth connection terminals 193 may be disposed between one of wires of the second semiconductor die 190 and one of the fourth redistribution vias 174. Each of the fourth connection terminals 193 may electrically connect one of wires of the second semiconductor die 190 to one of the fourth redistribution vias 174.

The second molding material 161 may be disposed on the upper redistribution structure 170 and cover the first semiconductor die 180, the third connection terminals 183, the second semiconductor die 190, and the fourth connection terminals 193. The second molding material 161 may protect the first semiconductor die 180, the third connection terminals 183, the second semiconductor die 190, and the third connection terminals 183 from the external environment.

For contents other than those described with respect to the sub-semiconductor package 100B of the embodiment of FIG. 12, the contents described with respect to the sub-semiconductor package 100A of the embodiment of FIG. 1 may be equally applied.

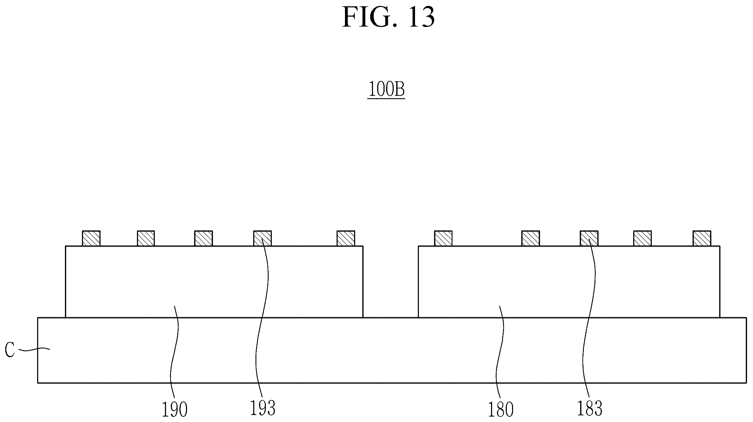

FIG. 13 to 23 are cross-sectional views for explaining a method of manufacturing the sub-semiconductor package 100B of an embodiment of FIG. 12. FIG. 13 to FIG. 23 are cross-sectional views showing a method of manufacturing the sub-semiconductor package 100B that applies a chip first process.

FIG. 13 is a cross-sectional view showing the step of attaching the first semiconductor die 180 and the second semiconductor die 190 on the carrier C.

Referring to FIG. 13, the first semiconductor die 180 and the second semiconductor die 190 may be attached on the carrier C. First, the carrier C may be provided. In an embodiment, the carrier C may include a silicon-based material such as glass and silicon oxide, another material such as organic material and aluminum oxide, or any combination of these materials. The first semiconductor die 180 may be attached to the carrier C such that an opposite surface of a surface on which the third connection terminals 183 is disposed may contact the carrier C. The second semiconductor die 190 may be attached to the carrier C such that an opposite surface of a surface on which the fourth connection terminals 193 is disposed may contact the carrier C. In an embodiment, each of the first semiconductor die 180 and the second semiconductor die 190 may be attached onto the carrier C by a die-attach film (not shown).

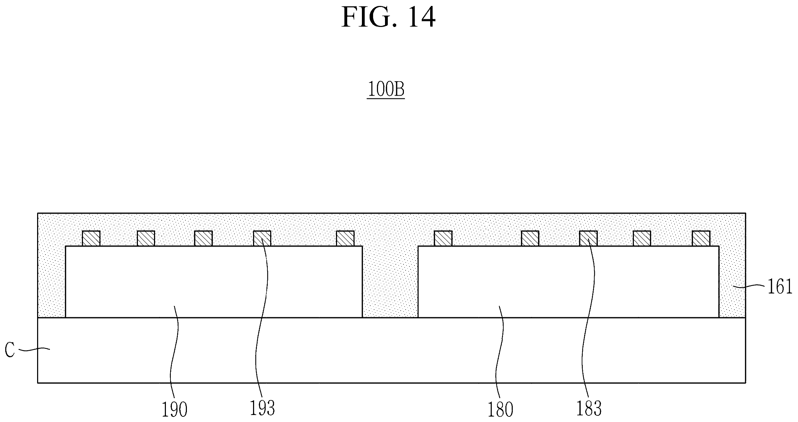

FIG. 14 is a cross-sectional view showing the step of molding the first semiconductor die 180, the third connection terminals 183, the second semiconductor die 190, and the fourth connection terminals 193 which are disposed on the carrier C.

Referring to FIG. 14, the first semiconductor die 180, the third connection terminals 183, the second semiconductor die 190, and the fourth connection terminals 193 may be molded using the second molding material 161. The second molding material 161 may be disposed onto the carrier C and cover the first semiconductor die 180, the third connection terminals 183, the second semiconductor die 190, and the fourth connection terminals 193. As an embodiment, the process of molding the second molding material 161 may include a compression molding or transfer molding process. In an embodiment, the second molding material 161 may include an epoxy molding compound (EMC).

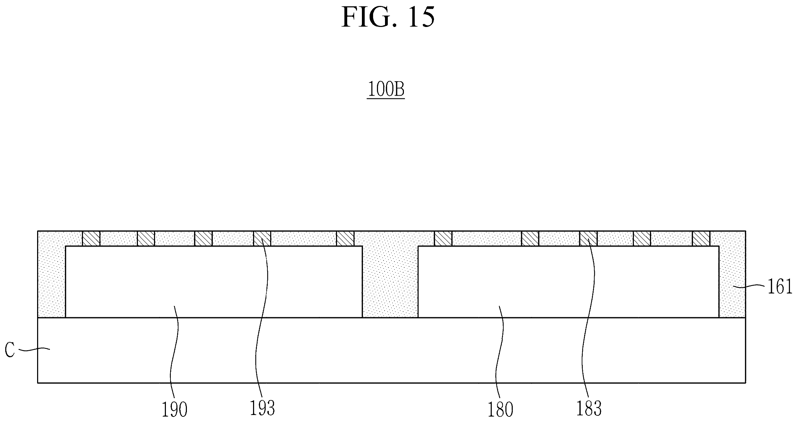

FIG. 15 is a cross-sectional view showing the step of performing a chemical mechanical planarization (CMP) process on the second molding material 161.

Referring to FIG. 15, in order to level the top surface of the second molding material 161, the top surface of the second molding material 161 may be planarized by performing a chemical mechanical planarization (CMP) process. After performing a chemical mechanical planarization (CMP) process, a top surface of the third connection terminals 183 and a top surface of the fourth connection terminals 193 may be exposed.

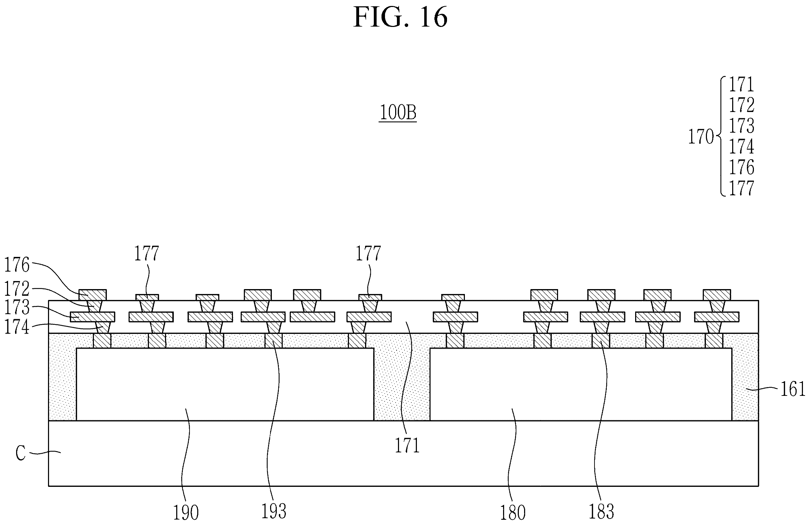

FIG. 16 is a cross-sectional view showing the step of forming the upper redistribution structure 170 on the third connection terminals 183, the fourth connection terminals 193, and the second molding material 161.

Referring to FIG. 16, the second dielectric material 171 may be formed on the third connection terminals 183, the fourth connection terminals 193, and the second molding material 161. In an embodiment, the second dielectric material 171 may include photoimageable dielectrics (PID) used in a redistribution layer process. In an embodiment, the second dielectric material 171 may be formed by performing a spin coating process.

After forming the second dielectric material 171, via holes may be formed by selectively etching the second dielectric material 171, and the fourth redistribution vias 174 may be formed by filling a conducting material into the via holes. After forming the fourth redistribution vias 174, the second dielectric material 171 may be additionally formed on the fourth redistribution vias 174 and the second dielectric material 171, openings may be formed by selectively etching the additionally formed second dielectric material 171, and the second redistribution lines 173 may be formed by filling a conducting material into the openings. After forming the second redistribution lines 173, the second dielectric material 171 may be additionally formed on the second redistribution lines 173 and the second dielectric material 171, via holes may be formed by selectively etching the additionally formed second dielectric material 171, and the third redistribution vias 172 may be formed by filling a conducting material into the via holes. After forming the third redistribution vias 172, photoresist may be additionally deposited on the third redistribution vias 172 and the second dielectric material 171, a photoresist pattern including via holes may be formed by selectively exposing and developing the photoresist, and the third bonding pads 176 and the fourth bonding pads 177 may be formed by filling a conducting material into the via holes. While being manufactured by the chip first process, each of the third redistribution vias 172 and the fourth redistribution vias 174 may have a shape in which the width increases from the bottom to the top, and in the sub-semiconductor package 100B, which is the final product, each of the third redistribution vias 172 and the fourth redistribution vias 174 may have a shape in which the width decreases from the bottom to the top.

In an embodiment, each of the third redistribution vias 172, the second redistribution lines 173, the fourth redistribution vias 174, the third bonding pads 176, and the fourth bonding pads 177 may include at least one of copper, aluminum, tungsten, nickel, gold, tin, titanium, and an alloy thereof. In an embodiment, each of the third redistribution vias 172, the second redistribution lines 173, the fourth redistribution vias 174, the third bonding pads 176, and the fourth bonding pads 177 may be formed by performing a sputtering process. In another embodiment, each of the third redistribution vias 172, the second redistribution lines 173, the fourth redistribution vias 174, the third bonding pads 176, and the fourth bonding pads 177 may be formed by performing an electroplating process after forming a seed metal layer.

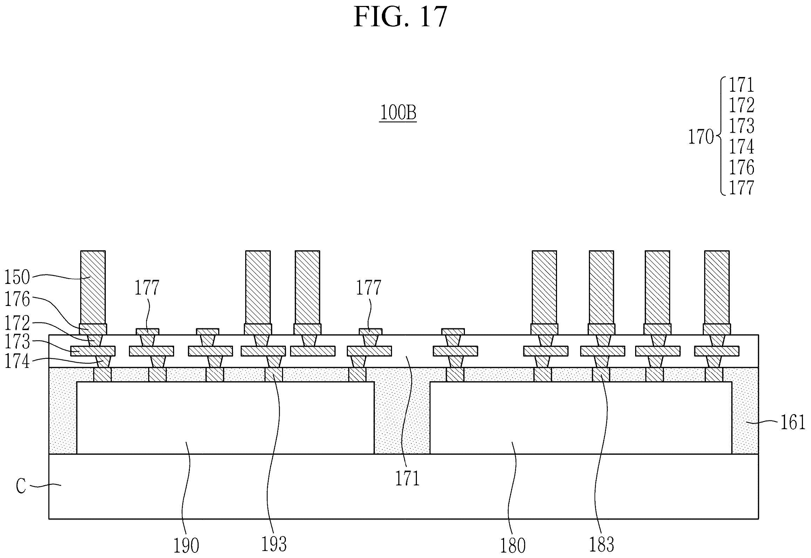

FIG. 17 is a cross-sectional view showing the step of forming the first connection members 150 on the upper redistribution structure 170.

Referring to FIG. 17, the first connection members 150 may be formed on the third bonding pads 176 of the upper redistribution structure 170. In an embodiment, the first connection members 150 may be formed by performing a sputtering process. In another embodiment, the first connection members 150 may be formed by performing an electroplating process after forming a seed metal layer. In an embodiment, the first connection members 150 may include at least one of copper, aluminum, tungsten, nickel, gold, silver, chromium, antimony, tin, titanium, and an alloy thereof.

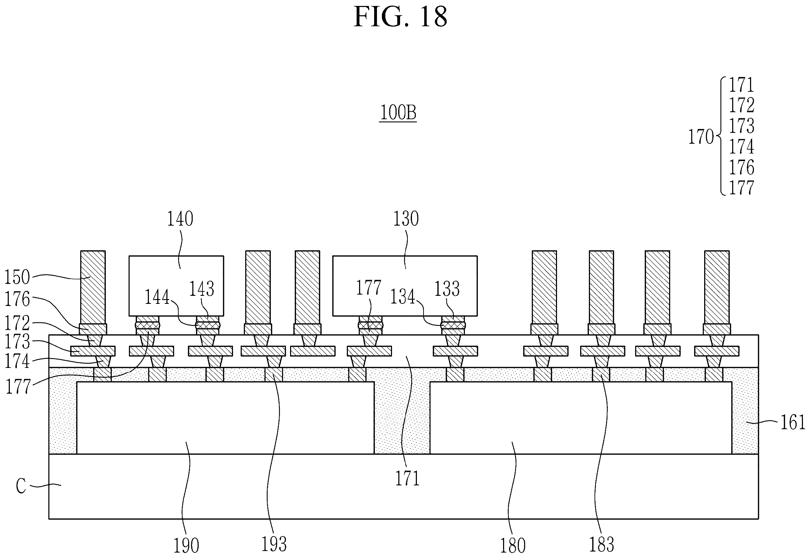

FIG. 18 is a cross-sectional view showing the step of mounting the bridge die 130 and the passive element die 140 on the upper redistribution structure 170.

Referring to FIG. 18, the bridge die 130 and the passive element die 140 may be mounted onto the upper redistribution structure 170. In an embodiment, each of the bridge die 130 and the passive element die 140 may be bonded onto the upper redistribution structure 170 by performing a flip chip bonding process. The bridge die 130 may be bonded to the fourth bonding pads 177 of the upper redistribution structure 170 by the third connection bumps 134, and the passive element die 140 may be bonded to the fourth bonding pads 177 of the upper redistribution structure 170 by the fourth connection bumps 144. The bridge die 130 and the upper redistribution structure 170 may be electrically connected to each other, and the passive element die 140 and the upper redistribution structure 170 may be electrically connected to each other. In an embodiment, each of the third connection bumps 134 and the fourth connection bumps 144 may include at least one of tin, silver, lead, nickel, copper, and an alloy thereof.

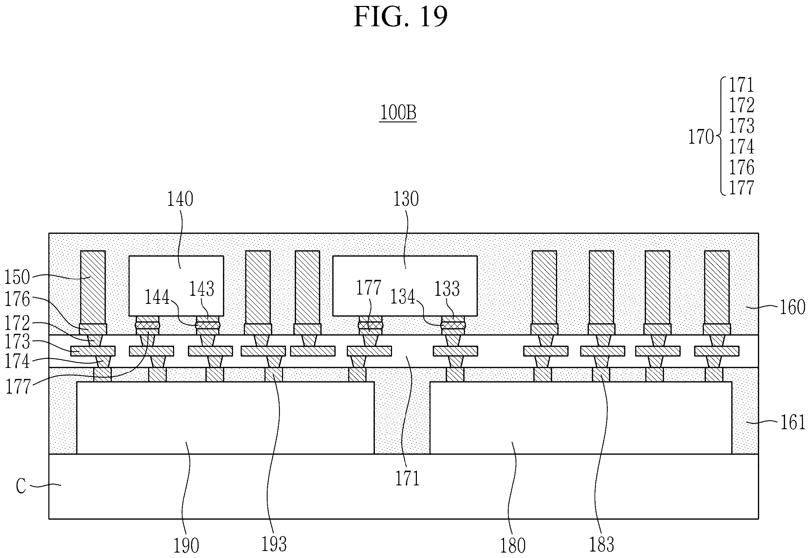

FIG. 19 is a cross-sectional view showing the step of molding the bridge die 130, the third connection pads 133, the third connection bumps 134, the passive element die 140, the fourth connection pads 143, the fourth connection bumps 144, and the first connection members 150 which are disposed on the upper redistribution structure 170.

Referring to FIG. 19, the bridge die 130, the third connection pads 133, the third connection bumps 134, the passive element die 140, the fourth connection pads 143, the fourth connection bumps 144, and the first connection members 150 may be molded using the first molding material 160. For example, the first molding material 160 may be disposed on the upper redistribution structure 170 and cover the bridge die 130, the third connection pads 133, the third connection bumps 134, the passive element die 140, the fourth connection pads 143, the fourth connection bumps 144, and the first connection members 150. As an embodiment, the process of molding the first molding material 160 may include a compression molding or transfer molding process. In an embodiment, the first molding material 160 may include an epoxy molding compound (EMC).

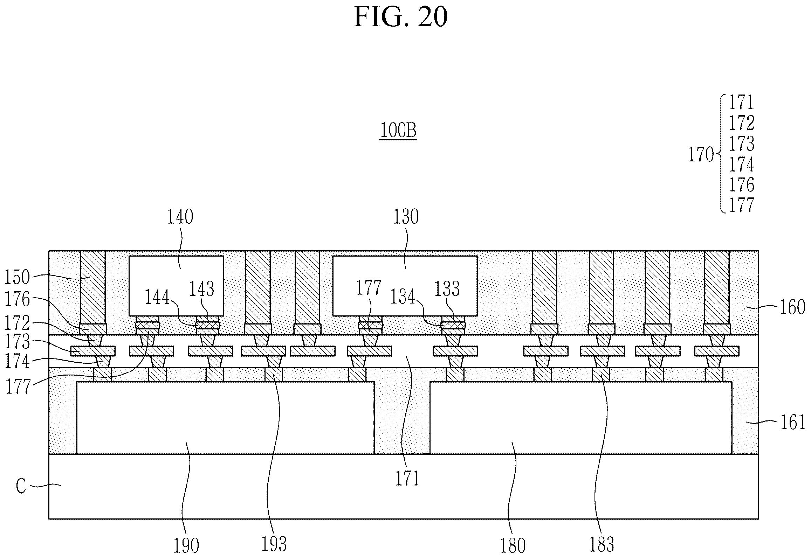

FIG. 20 is a cross-sectional view showing the step of performing a chemical mechanical planarization (CMP) process on the first molding material 160.

Referring to FIG. 20, in order to level the top surface of the first molding material 160, the top surface of the first molding material 160 may be planarized by performing a chemical mechanical planarization (CMP) process. After performing a chemical mechanical planarization (CMP) process, the top surface of the first connection members 150 may be exposed.

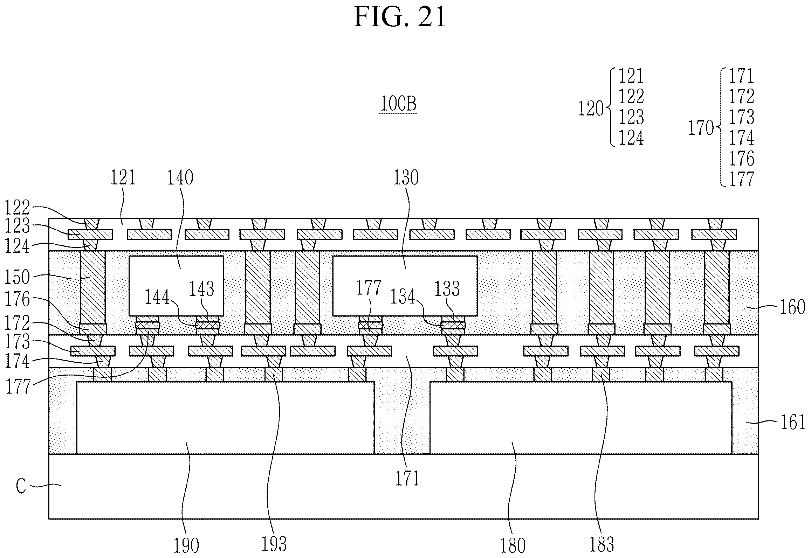

FIG. 21 is a cross-sectional view showing the step of forming the lower redistribution structure 120 on the first connection members 150 and the first molding material 160.

Referring to FIG. 21, the second dielectric material 171 may be formed on the first connection members 150 and the first molding material 160. In an embodiment, the first dielectric material 121 may include photoimageable dielectrics (PID) used in a redistribution layer process. In an embodiment, the first dielectric material 121 may be formed by performing a spin coating process.

After forming the first dielectric material 121, via holes may be formed by selectively etching the first dielectric material 121, and the second redistribution vias 124 may be formed by filling a conducting material into the via holes. After forming the second redistribution vias 124, the first dielectric material 121 may be additionally formed on the second redistribution vias 124 and the first dielectric material 121, openings may be formed by selectively etching the additionally formed first dielectric material 121, and the first redistribution lines 123 may be formed by filling a conducting material into the openings. After forming the first redistribution lines 123, the first dielectric material 121 may be additionally formed on the first redistribution lines 123 and the first dielectric material 121, via holes may be formed by selectively etching the additionally formed first dielectric material 121, and the first redistribution vias 122 may be formed by filling a conducting material into the via holes. While being manufactured by the chip first process, each of the first redistribution vias 122 and the second redistribution vias 124 may have a shape in which the width increases from the bottom to the top, and in the sub-semiconductor package 100B, which is the final product, each of the first redistribution vias 122 and the second redistribution vias 124 may have a shape in which the width decreases from the bottom to the top.

In an embodiment, each of the first redistribution vias 122, the first redistribution lines 123, and the second redistribution vias 124 may include at least one of copper, aluminum, tungsten, nickel, gold, tin, titanium, and an alloy thereof. In an embodiment, each of the first redistribution vias 122, the first redistribution lines 123, and the second redistribution vias 124 may be formed by performing a sputtering process. In another embodiment, each of the first redistribution vias 122, the first redistribution lines 123, and the second redistribution vias 124 may be formed by performing an electroplating process after forming a seed metal layer.

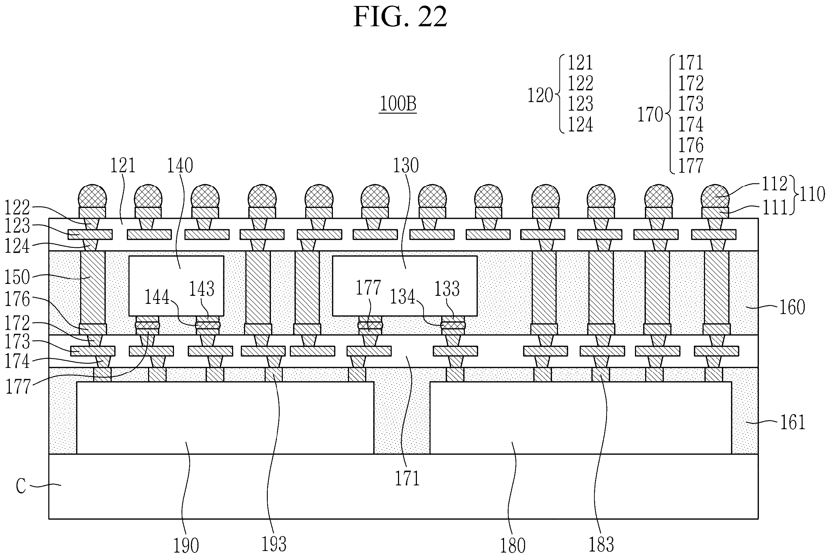

FIG. 22 is a cross-sectional view showing the step of forming the connection structure 110 on the lower redistribution structure 120.

Referring to FIG. 22, the connection structure 110 may be formed on the lower redistribution structure 120. The conductive pads 111 may be formed on the first redistribution vias 122 of the lower redistribution structure 120. In an embodiment, the conductive pads 111 may include at least one of copper, nickel, zinc, gold, silver, platinum, palladium, chromium, titanium, and an alloy thereof. In an embodiment, the conductive pads 111 may be formed by a sputtering process or by performing an electroplating process after forming a seed metal layer. Thereafter, the connection bumps 112 may be formed below the conductive pads 111. In an embodiment, the connection bumps 112 may include at least one of tin, silver, lead, nickel, copper, and an alloy thereof.

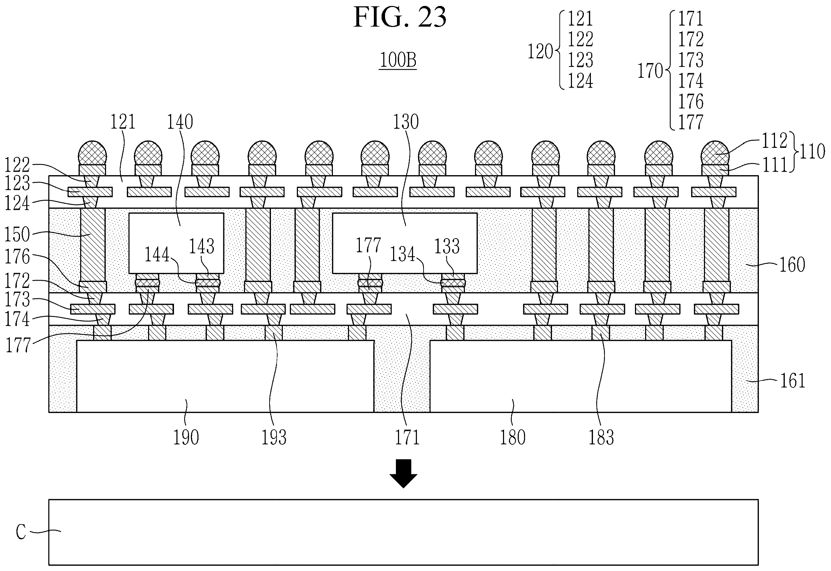

FIG. 23 is a cross-sectional view showing the step of removing the carrier C from the lower redistribution structure 120.

Referring to FIG. 23, the carrier C may be removed from the lower redistribution structure 120.

FIG. 24 is a cross-sectional view showing the semiconductor package 200A of an embodiment.

Referring to FIG. 24, the semiconductor package 200A may include an external connection structure 210, front-side redistribution structure (first redistribution structure) 220, the sub-semiconductor package 100A (or the sub-semiconductor package 100B), second connection members 250, a third molding material 260, back-side redistribution structure (fourth redistribution structure) 270, a third semiconductor die 280, and a fourth molding material 261. In an embodiment, the semiconductor package 200A may include a package-on-package (PoP). In an embodiment, the semiconductor package 200A may be manufactured based on the fan-out wafer level package (FOWLP) or fan-out panel level package (FOPLP) technology.

The external connection structure 210 may be disposed on a bottom surface of the front-side redistribution structure 220. The external connection structure 210 may include conductive pads 211 and external connection bumps 212. Each of the conductive pads 211 may be disposed between one of the external connection bumps 212 and one of a fifth redistribution vias 222 of the front-side redistribution structure 220. Each of the conductive pads 211 may electrically connect one of the fifth redistribution vias 222 of the front-side redistribution structure 220 to one of the external connection bumps 212. The external connection bumps 212 may electrically connect the semiconductor package 200A to external device (not shown). In an embodiment, the conductive pads 211 may include at least one of copper, nickel, zinc, gold, silver, platinum, palladium, chromium, titanium, and an alloy thereof. In an embodiment, the external connection bumps 212 may include at least one of tin, silver, lead, nickel, copper, and an alloy thereof.

The front-side redistribution structure 220 may include a third dielectric material 221, the fifth redistribution vias 222, third redistribution lines 223 and a sixth redistribution vias 224 within the third dielectric material 221, and fifth bonding pads 225 and sixth bonding pads 226 on the third dielectric material 221. In another embodiment, the front-side redistribution structure 220 including a smaller or larger number of redistribution lines, redistribution vias, and bonding pads may be included in the scope of the present disclosure.

The third dielectric material 221 may protect and insulate the fifth redistribution vias 222, the third redistribution lines 223 and the sixth redistribution vias 224. The fifth bonding pads 225, the sixth bonding pads 226, and the third molding material 260 may be disposed on a top surface of the third dielectric material 221. An external connection structure 110 may be disposed on a bottom surface of the third dielectric material 221. In an embodiment, the third dielectric material 221 may include photoimageable dielectrics (PID) used in a redistribution layer process.

Each of the fifth redistribution vias 222 may be disposed between one of the conductive pads 211 and one of the third redistribution lines 223. Each of the fifth redistribution vias 222 may electrically connect one of the third redistribution lines 223 to one of the conductive pads 211. Each of the third redistribution lines 223 may be disposed between one of the fifth redistribution vias 222 and one of the sixth redistribution vias 224. Each of the third redistribution lines 223 may electrically connect one of the sixth redistribution vias 224 to one of the fifth redistribution vias 222. Each of the sixth redistribution vias 224 may be disposed between one of the third redistribution lines 223 and one of the fifth bonding pads 225, or between one of the third redistribution lines 223 and one of the sixth bonding pads 226. Each of the sixth redistribution vias 224 may electrically connect one of the fifth bonding pads 225 to one of the third redistribution lines 223, or one of the sixth bonding pads 226 to one of the third redistribution lines 223. Each of the fifth bonding pads 225 may be disposed between one of the sixth redistribution vias 224 and one of the second connection members 250. Each of the fifth bonding pads 225 may electrically connect one of the second connection members 250 to one of the sixth redistribution vias 224. Each of the sixth bonding pads 226 may be disposed between one of the sixth redistribution vias 224 and one of the connection bumps 112 of the sub-semiconductor package 100A. Each of the sixth bonding pads 226 may electrically connect one of the connection bumps 112 of the sub-semiconductor package 100A to one of the sixth redistribution vias 224. In an embodiment, each of the fifth redistribution vias 222, the third redistribution lines 223, the sixth redistribution vias 224, the fifth bonding pads 225, and the sixth bonding pads 226 may include at least one of copper, aluminum, tungsten, nickel, gold, tin, titanium, and an alloy thereof.

The sub-semiconductor package 100A may be disposed on the front-side redistribution structure 220. The sub-semiconductor package 100A may be disposed side by side with the second connection members 250. The sub-semiconductor package 100A may be replaced with the sub-semiconductor package 100B of FIG. 12. Regarding the sub-semiconductor package 100A or 100B, the contents described with respect to the sub-semiconductor package 100A or 100B with reference to FIG. 1 or FIG. 12 may be equally applied.

The second connection members 250 may be disposed on the front-side redistribution structure 220. In an embodiment, the second connection members 250 may include conductive posts. The second connection members 250 may be disposed around the sub-semiconductor package 100A. The second connection members 250 may be disposed beside the sub-semiconductor package 100A. Each of the second connection members 250 may be disposed between one of the fifth bonding pads 225 of the front-side redistribution structure 220 and one of seventh redistribution vias 272 of a back-side redistribution structure 270. Each of the second connection members 250 may electrically connect one of the seventh redistribution vias 272 of the back-side redistribution structure 270 to one of the fifth bonding pads 225 of the front-side redistribution structure 220. The second connection members 250 may be disposed to penetrate the third molding material 260. A side surface of the second connection members 250 may be surrounded by the third molding material 260. In an embodiment, the second connection members 250 may include at least one of copper, aluminum, tungsten, nickel, gold, silver, chromium, antimony, tin, titanium, and an alloy thereof.

According to the present disclosure, the bridge die 130 and the passive element die 140 may be disposed within the sub-semiconductor package 100A, and the sub-semiconductor package 100A may be disposed on the front-side redistribution structure 220. Accordingly, routing paths of the bridge die 130 may not be formed in the front-side redistribution structure 220, and accordingly, the total number of layers of the front-side redistribution structure 220 may be reduced.

The third molding material 260 may be disposed on the front-side redistribution structure 220 and cover the sub-semiconductor package 100A and the second connection members 250. The third molding material 260 may protect the sub-semiconductor package 100A and the second connection members 250 from the external environment. In an embodiment, the third molding material 260 may include an epoxy molding compound (EMC).

According to the present disclosure, the bridge die 130 and the passive element die 140 may be disposed within the sub-semiconductor package 100A, and may be covered by the third molding material 260 that covers the sub-semiconductor package 100A and the first molding material 160 within the sub-semiconductor package 100A. Accordingly, the bridge die 130 and the passive element die 140 are not exposed to the outside, and double-covered by the first molding material 160 and the third molding material 260, thereby being protected from the external environment.

The back-side redistribution structure 270 may include a fourth dielectric material 271, the seventh redistribution vias 272, fourth redistribution lines 273 and an eighth redistribution vias 274 within the fourth dielectric material 271, and seventh bonding pads 275 on the fourth dielectric material 271. In another embodiment, the back-side redistribution structure 270 including a smaller or larger number of redistribution lines, redistribution vias, and bonding pads may be included in the scope of the present disclosure.

The fourth dielectric material 271 may protect and insulate the seventh redistribution vias 272, the fourth redistribution lines 273 and the eighth redistribution vias 274. The seventh bonding pads 275 and the fourth molding material 261 may be disposed on a top surface of the fourth dielectric material 271. The second connection members 250 and the third molding material 260 may be disposed on a bottom surface of the fourth dielectric material 271. In an embodiment, the fourth dielectric material 271 may include photoimageable dielectrics (PID) used in a redistribution layer process.

Each of the seventh redistribution vias 272 may be disposed between one of the second connection members 250 and one of the fourth redistribution lines 273. Each of the seventh redistribution vias 272 may electrically connect one of the fourth redistribution lines 273 to one of the second connection members 250. Each of the fourth redistribution lines 273 may be disposed between one of the seventh redistribution vias 272 and one of the eighth redistribution vias 274. Each of the fourth redistribution lines 273 may electrically connect one of the eighth redistribution vias 274 to one of the seventh redistribution vias 272. Each of the eighth redistribution vias 274 may be disposed between one of the fourth redistribution lines 273 and one of the seventh bonding pads 275. Each of the eighth redistribution vias 274 may electrically connect one of the seventh bonding pads 275 to one of the fourth redistribution lines 273. Each of the seventh bonding pads 275 may be disposed between one of the eighth redistribution vias 274 and one of fifth connection bumps 282. Each of the seventh bonding pads 275 may electrically connect one of the fifth connection bumps 282 to one of the eighth redistribution vias 274. In an embodiment, each of the seventh redistribution vias 272, the fourth redistribution lines 273, the eighth redistribution vias 274, and the seventh bonding pads 275 may include at least one of copper, aluminum, tungsten, nickel, gold, tin, titanium, and an alloy thereof.

The third semiconductor die 280 may be disposed on the back-side redistribution structure 270. In an embodiment, the third semiconductor die 280 may include a memory die. In an embodiment, the third semiconductor die 280 may include a DRAM or high bandwidth memory (HBM). The third semiconductor die 280 may be connected to the back-side redistribution structure 270 through fifth connection pads 281 and the fifth connection bumps 282. Each of the fifth connection pads 281 may be disposed between the third semiconductor die 280 and one of the fifth connection bumps 282. Each of the fifth connection pads 281 may electrically connect the third semiconductor die 280 to one of the fifth connection bumps 282 in the vertical direction. Each of the fifth connection bumps 282 may be disposed between one of the seventh bonding pads 275 and one of the fifth connection pads 281. Each of the fifth connection bumps 282 may electrically connect one of the fifth connection pads 281 to one of the seventh bonding pads 275. In an embodiment, the fifth connection bumps 282 may include at least one of tin, silver, lead, nickel, copper, and an alloy thereof.

The fourth molding material 261 may be disposed on the back-side redistribution structure 270 and cover the third semiconductor die 280, the fifth connection pads 281, and the fifth connection bumps 282. The fourth molding material 261 may protect the third semiconductor die 280, the fifth connection pads 281, and the fifth connection bumps 282 from the external environment. In an embodiment, the fourth molding material 261 may include an epoxy molding compound (EMC). A top surface of the third semiconductor die 280 may be exposed to the outside from the fourth molding material 261.

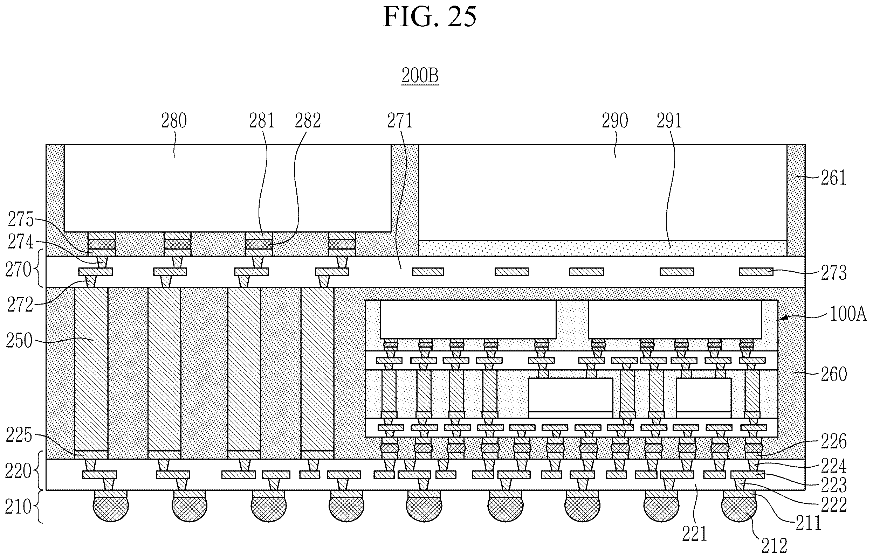

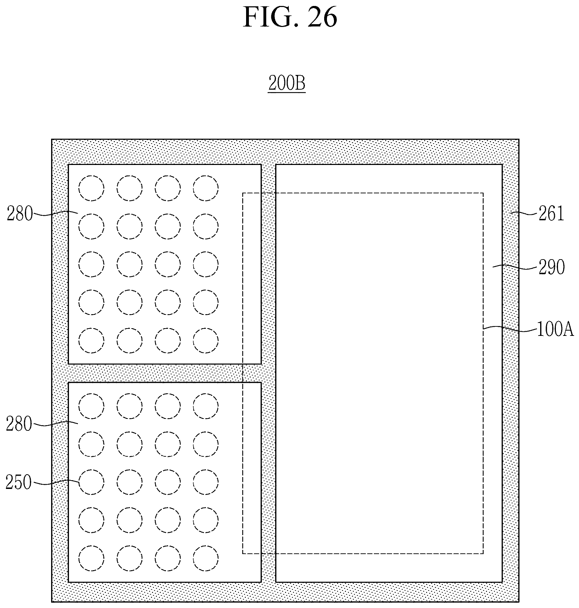

FIG. 25 is a cross-sectional view showing a semiconductor package 200B of an embodiment. FIG. 26 is a top plan view showing a top surface of the semiconductor package 200B of the embodiment of FIG. 25. In FIG. 26, the sub-semiconductor package 100A and the second connection members 250 are shown in dotted lines.

Referring to FIG. 25 and FIG. 26, the semiconductor package 200A may include an asymmetric package-on-package (PoP). The second connection members 250 may be disposed beside one side of the sub-semiconductor package 100A. The sub-semiconductor package 100A may be replaced with the sub-semiconductor package 100B of FIG. 12. The semiconductor package 200A may include a heat dissipation structure 290. The heat dissipation structure 290 may be disposed on the back-side redistribution structure 270, and beside the third semiconductor die 280. The heat dissipation structure 290 may dissipate heat generated within the sub-semiconductor package 100A, or within the semiconductor package 200B, and thereby improve the thermal characteristics of the semiconductor package 200B. In an embodiment, the heat dissipation structure 290 may include a heat spreader.

The heat dissipation structure 290 may be attached on the back-side redistribution structure 270 by a third adhesive member 291. In an embodiment, the third adhesive member 291 may include an adhesive tape, Ag paste, epoxy resin, polyimide, or thermal interface materials (TIM). the thermal interface material (TIM) is a material inserted to improve thermal coupling between the back-side redistribution structure 270 and the heat dissipation structure 290, which are devices to dissipate the heat. the thermal interface material (TIM) may serve to reduce the thermal contact resistance by filling an air layer of a contact surface between the back-side redistribution structure 270 and the heat dissipation structure 290. In an embodiment, thermal interface material (TIM) may include thermal paste, thermal pad, phase change material (PCM), grease, or metal material.

Electrical signals between the sub-semiconductor package 100A and the third semiconductor die 280 may be routed through the second connection members 250, a signal transmission path between the sub-semiconductor package 100A and the third semiconductor die 280 in the semiconductor package 200B having an asymmetry structure may be set as a shortest distance, and in order to improve the signal characteristics of the semiconductor package 200B, a footprint of the second connection members 250 may be included within a footprint of the third semiconductor die 280.

A path through which the heat generated at the sub-semiconductor package 100A is dissipated to the outside through the heat dissipation structure 290 may be set as a shortest distance, and in order to improve the heating characteristics of the semiconductor package 200B, a footprint of the sub-semiconductor package 100A may overlap with a footprint of the heat dissipation structure 290.

For contents other than those described with respect to the semiconductor package 200B of the embodiment of FIG. 25 and FIG. 26, the contents described with respect to the semiconductor package 200A of the embodiment of FIG. 24 may be equally applied.

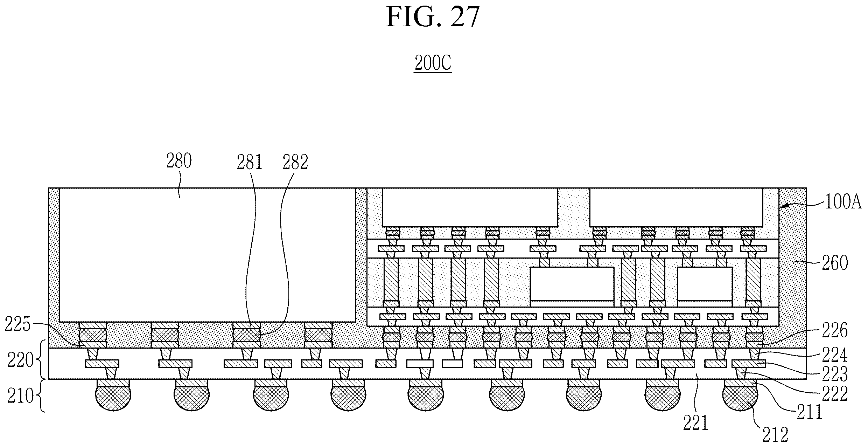

FIG. 27 is a cross-sectional view showing a semiconductor package 200C of an embodiment.

Referring to FIG. 27, the sub-semiconductor package 100A and the third semiconductor die 280 may be disposed on the front-side redistribution structure 220. The sub-semiconductor package 100A and the third semiconductor die 280 may be side by side disposed on the front-side redistribution structure 220. The sub-semiconductor package 100A may be replaced with the sub-semiconductor package 100B of FIG. 12. The third semiconductor die 280 may be connected to the front-side redistribution structure 220 through the fifth connection pads 281 and the fifth connection bumps 282. Each of the fifth connection pads 281 may be disposed between the third semiconductor die 280 and one of the fifth connection bumps 282. Each of the fifth connection pads 281 may electrically connect the third semiconductor die 280 to one of the fifth connection bumps 282 in the vertical direction. Each of the fifth connection bumps 282 may be disposed between one of the fifth bonding pads 225 and one of the fifth connection pads 281. Each of the fifth connection bumps 282 may electrically connect one of the fifth connection pads 281 to one of the fifth bonding pads 225.

The third molding material 260 may be disposed on the front-side redistribution structure 220 and cover the sub-semiconductor package 100A, the third semiconductor die 280, the fifth connection pads 281, and the fifth connection bumps 282. The third molding material 260 may protect the sub-semiconductor package 100A, the third semiconductor die 280, the fifth connection pads 281, and the fifth connection bumps 282 from the external environment. In an embodiment, the third molding material 260 may include an epoxy molding compound (EMC). A top surface of the sub-semiconductor package 100A and the top surface of the third semiconductor die 280 may be exposed to the outside from the third molding material 260.

For contents other than those described with respect to the semiconductor package 200C of the embodiment of FIG. 27, the contents described with respect to the semiconductor package 200A of the embodiment of FIG. 24 may be equally applied.

According to the present disclosure, the sub-semiconductor package 100A including the bridge die 130, the passive element die 140, the first semiconductor die 180, and the second semiconductor die 190 may not be limited to the embodiment of FIG. 24, FIG. 25 and FIG. 27, but may be applied to various platforms.

While this disclosure has been described in connection with what is presently considered to be practical embodiments, it is to be understood that the invention is not limited to the disclosed embodiments, but, on the contrary, is intended to cover various modifications and equivalent arrangements included within the scope of the appended claims.

## Claims

1. A semiconductor package, comprising:
a first redistribution structure (220);
a sub-semiconductor package (100A, 100B) on the first redistribution structure (220),
wherein the sub-semiconductor package (100A, 100B) comprises:
a second redistribution structure (120);
a bridge die (130) on an upper surface of the second redistribution structure (120);
a first molding material (160) disposed on the upper surface of the second redistribution structure (120) and configured to cover the bridge die (130) disposed on the upper surface of the second redistribution structure (120);
a plurality of connection structures (110) disposed on a lower surface of the second redistribution structure (120) and connected to the first redistribution structure (220);
a third redistribution structure (170) on the first molding material (160) and on the bridge die (130);
a first semiconductor die (180) on the third redistribution structure (170);
a second semiconductor die (190) on the third redistribution structure (170), and beside the first semiconductor die (180), wherein the second semiconductor die (190) is electrically connected to the first semiconductor die (180) through the bridge die (130); and
a second molding material (161) configured to cover the first semiconductor die (180) and the second semiconductor die (190), on the third redistribution structure (170); and
a third molding material (260) configured to cover the sub-semiconductor package (100A, 100B), on the first redistribution structure (220).

2. The semiconductor package of claim 1,
wherein the sub-semiconductor package (100A, 100B) further comprises a first adhesive member (132) between the second redistribution structure (120) and the bridge die (130).

3. The semiconductor package of claim 1 or 2,
wherein:
the sub-semiconductor package (100A, 100B) further comprises a passive element die (140) on the upper surface of the second redistribution structure (120) and beside the bridge die (130);
the first molding material (160) is configured to cover the passive element die on the second redistribution structure (120); and
the bridge die (130) and the passive element die (140) overlap some of the plurality of connection structures (110).

4. The semiconductor package of claim 3,
wherein the passive element die (140) comprises an integrated stack capacitor.

5. The semiconductor package of claim 3 or 4,
wherein the sub-semiconductor package (100A, 100B) further comprises a second adhesive member (142) between the second redistribution structure (120) and the passive element die (140).

6. The semiconductor package of any one of claims 1 to 5,
wherein each of the first semiconductor die (180) and the second semiconductor die (190) comprises an application processor, AP.

7. The semiconductor package of any one of claims 1 to 6,
wherein the bridge die (130) comprises a silicon bridge die.

8. The semiconductor package of any one of claims 1 to 7, further comprising:
a plurality of first connection members (150) on the second redistribution structure (120) and beside the bridge die (130);
a plurality of second connection members (250) disposed on the first redistribution structure (220);
a fourth redistribution structure (270) disposed on the third molding material (260) and the plurality of second connection members (250); and
a third semiconductor die (280) disposed on the fourth redistribution structure (270), wherein
the first molding material (160) is configured to cover the plurality of first connection members (150),
the third redistribution structure (170) is disposed the plurality of first connection members (150), and
the third molding material (260) is configured to cover the plurality of second connection members (250).

9. The semiconductor package of claim 8, further comprising a heat dissipation structure (290) disposed on the fourth redistribution structure (270) and beside the third semiconductor die (280).

10. The semiconductor package of claim 9, further comprising a thermal interface material, TIM, disposed between the fourth redistribution structure (270) and the heat dissipation structure (290).

11. The semiconductor package of claim 9 or 10,
wherein a footprint of the sub-semiconductor package (100A, 100B) overlaps a footprint of the heat dissipation structure 290).

12. The semiconductor package of any one of claims 8 to 11,
wherein the plurality of second connection members (250) surround the sub-semiconductor package (100A, 100B).

13. The semiconductor package of any one of claims 8 to 12,
wherein the plurality of second connection members (250) is disposed beside one side of the sub-semiconductor package (100A, 100B).

14. The semiconductor package of any one of claims 8 to 13,
wherein footprints of the plurality of second connection members (250) are disposed within a footprint of the third semiconductor die (280) when viewed in a plan view.

15. The semiconductor package of any one of claims 1 to 7, further comprising:
a plurality of first connection members (150) on the second redistribution structure (120); and
a third semiconductor die (280) on the first redistribution structure (220) and beside the sub-semiconductor package (100A, 100B), wherein:
the first molding material (160) is configured to cover the plurality of first connection members (150),
the third redistribution structure (170) is disposed on the plurality of first connection members (150), and
the third molding material (260) is configured to cover the third semiconductor die (280).

## Amended claims

### Amended claims in accordance with Rule 137(2) EPC.

1. A semiconductor package, comprising:
a first redistribution structure (220);
a sub-semiconductor package (100B) on the first redistribution structure (220),
wherein the sub-semiconductor package (100B) comprises:
a second redistribution structure (120);
a bridge die (130) on an upper surface of the second redistribution structure (120);
a first molding material (160) disposed on the upper surface of the second redistribution structure (120) and configured to cover the bridge die (130) disposed on the upper surface of the second redistribution structure (120) and to fill between the second redistribution structure (120) and the bridge die (130);
a plurality of connection structures (110) disposed on a lower surface of the second redistribution structure (120) and connected to the first redistribution structure (220);
a third redistribution structure (170) on the first molding material (160) and on the bridge die (130);
a first semiconductor die (180) on the third redistribution structure (170);
a second semiconductor die (190) on the third redistribution structure (170), and beside the first semiconductor die (180), wherein the second semiconductor die (190) is electrically connected to the first semiconductor die (180) through the bridge die (130); and
a second molding material (161) configured to cover the first semiconductor die (180) and the second semiconductor die (190), on the third redistribution structure (170); and
a third molding material (260) configured to cover the sub-semiconductor package (100B), on the first redistribution structure (220).

2. The semiconductor package of claim 1,
wherein:
the sub-semiconductor package (100B) further comprises a passive element die (140) on the upper surface of the second redistribution structure (120) and beside the bridge die (130);
the first molding material (160) is configured to cover the passive element die on the second redistribution structure (120); and
the bridge die (130) and the passive element die (140) overlap some of the plurality of connection structures (110).

3. The semiconductor package of claim 2,
wherein the passive element die (140) comprises an integrated stack capacitor.

4. The semiconductor package of claim 2 or 3,
wherein the first molding material (160) is configured to fill between the second redistribution structure (120) and the passive element die (140).

5. The semiconductor package of any one of claims 1 to 4,
wherein each of the first semiconductor die (180) and the second semiconductor die (190) comprises an application processor, AP.

6. The semiconductor package of any one of claims 1 to 5,
wherein the bridge die (130) comprises a silicon bridge die.

7. The semiconductor package of any one of claims 1 to 6, further comprising:
a plurality of first connection members (150) on the second redistribution structure (120) and beside the bridge die (130);
a plurality of second connection members (250) disposed on the first redistribution structure (220);
a fourth redistribution structure (270) disposed on the third molding material (260) and the plurality of second connection members (250); and
a third semiconductor die (280) disposed on the fourth redistribution structure (270), wherein
the first molding material (160) is configured to cover the plurality of first connection members (150),
the third redistribution structure (170) is disposed on the plurality of first connection members (150), and
the third molding material (260) is configured to cover the plurality of second connection members (250).

8. The semiconductor package of claim 7, further comprising a heat dissipation structure (290) disposed on the fourth redistribution structure (270) and beside the third semiconductor die (280).

9. The semiconductor package of claim 8, further comprising a thermal interface material, TIM, disposed between the fourth redistribution structure (270) and the heat dissipation structure (290).

10. The semiconductor package of claim 8 or 9,
wherein a footprint of the sub-semiconductor package (100B) overlaps a footprint of the heat dissipation structure 290).

11. The semiconductor package of any one of claims 7 to 10,
wherein the plurality of second connection members (250) surround the sub-semiconductor package (100B).

12. The semiconductor package of any one of claims 7 to 11,
wherein the plurality of second connection members (250) is disposed beside one side of the sub-semiconductor package (100B).

13. The semiconductor package of any one of claims 7 to 12,
wherein footprints of the plurality of second connection members (250) are disposed within a footprint of the third semiconductor die (280) when viewed in a plan view.

14. The semiconductor package of any one of claims 1 to 6, further comprising:
a plurality of first connection members (150) on the second redistribution structure (120); and
a third semiconductor die (280) on the first redistribution structure (220) and beside the sub-semiconductor package (100B), wherein:
the first molding material (160) is configured to cover the plurality of first connection members (150),
the third redistribution structure (170) is disposed on the plurality of first connection members (150), and
the third molding material (260) is configured to cover the third semiconductor die (280).
